Europäisches Patentamt

European Patent Office

Office européen des brevets

(19)

(11) **EP 0 602 249 B1**

(12) **EUROPEAN PATENT SPECIFICATION**

(45) Date of publication and mention
of the grant of the patent:
**28.08.2002 Bulletin 2002/35**

(51) Int Cl.$^7$: **H04L 7/08**, H04L 25/08,
H03M 13/00, H04B 3/10,
H04L 7/04, H04L 25/03

(21) Application number: **93913537.2**

(22) Date of filing: **17.06.1993**

(86) International application number:
**PCT/JP93/00817**

(87) International publication number:
**WO 93/026106 (23.12.1993 Gazette 1993/30)**

(54) **MAXIMUM LIKELIHOOD SEQUENCE ESTIMATING DEVICE AND METHOD THEREFOR**

VORRICHTUNG UND VERFAHREN ZUR MAXIMAL
WAHRSCHEINLICHKEITSFOLGESCHÄTZUNG

DISPOSITIF ET PROCEDE D'ESTIMATION DE SEQUENCE PROBABILISTE MAXIMALE

(84) Designated Contracting States:
**DE FR GB IT SE**

(30) Priority: **18.06.1992 JP 15947592**

(43) Date of publication of application:
**22.06.1994 Bulletin 1994/25**

(73) Proprietor: **Oki Electric Industry Company,
Limited
Tokyo 105 (JP)**

(72) Inventors:
• **YAMAGUCHI, Norio
Oki Electric Industry Co., Ltd.
Minato-ku Tokyo 105 (JP)**

• **SHIINO, Haruhiro Oki Electric Industry Co., Ltd.
Tokyo 105 (JP)**

(74) Representative: **Read, Matthew Charles et al
Venner Shipley & Co.
20 Little Britain
London EC1A 7DH (GB)**

(56) References cited:
**EP-A- 0 544 315          GB-A- 2 242 339
JP-A- 4 088 726           JP-A- 4 502 695
JP-A- 4 503 143           JP-A- 63 169 846
JP-A- 64 024 535          JP-U- 57 181 152**

## Description

The present invention relates to a maximum likelihood sequence estimator for compensating waveform distortions that occur over transmission paths, in receivers, for example in digital mobile telephony.

Lately, development of digital mobile telephone systems has proceeded rapidly. However, there has been a problem that, in land digital mobile telephony, waveforms of reception signals would be considerably distorted due to a number of interference waves which bring about the delay in reception and frequency selective fading which is caused by high speed movement of mobile terminals. Therefore this distortion should be compensated by an equalizer. Maximum likelihood sequence estimation is one of the most effective equalization methods for obtaining correct transmission data from reception signal waveforms which have been distorted due to delay characteristics of the transmission paths, such as frequency selective fading.

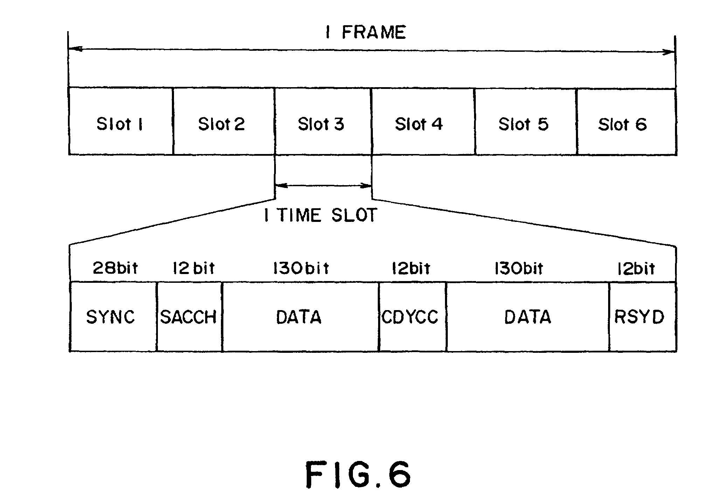

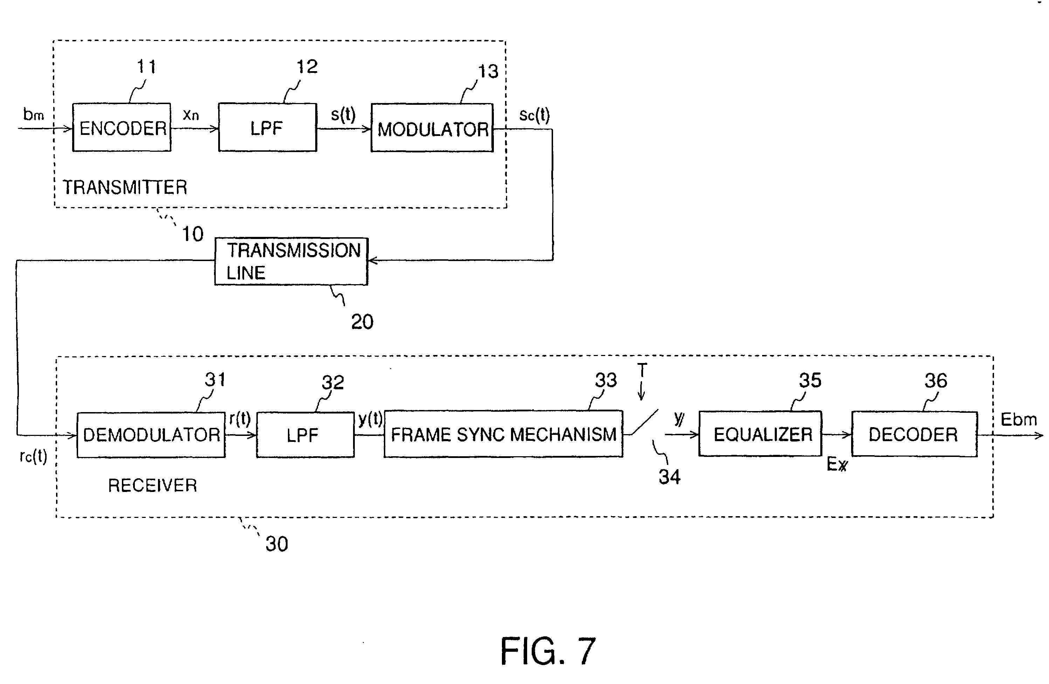

A conventional digital mobile telephone system will now be described with references to Figs. 6 and 7. The digital mobile telephone system makes use of the TDMA (Time Division Multiple Access) scheme to efficiently use limited radio frequency bands and ensure easy connection to the ISDN (Integrated Service Digital Network) services which have been implemented for the fixed telecommunications networks. An example of the frame configuration of TDMA scheme is shown in Fig. 6.

In Fig. 6, one frame comprises six time slots Slot 1-6. One or two of these time slots are assigned to one subscriber. Time slots 1-6 respectively consist of a 28-bit training sequence SYNC for synchronisation and training of an equaliser, a 12-bit control information sequence SACCH, a 12-bit adjacent channel identification sequence CDVCC, data part DATA of 260 bits in total, and a 12-bit reserved area RSVD.

The leading position t slot (k) of the time slot assigned to each subscriber is detected by the frame synchronisation mechanism. The position to be detected by the frame synchronisation mechanism is an estimated leading position Et slot (k) (E means estimation) to be determined by estimation. This estimated leading position Et slot (k) is merely an estimated position and therefore is not always an accurate position, and therefore it may vary depending on compensation by the frame synchronization mechanism.

Fig.7 is a block diagram showing the configuration of the transmitter and the receiver for digital mobile telephony.

In this transmitter/receiver configuration, the receiver 30 is connected to the output side of the transmitter 10 through the transmission line 20.

The transmitter 10 is composed of an encoder 11, a transmission low-pass filter (LPF) 12, a modulator 13 and other parts.

The receiver 30 is composed of a demodulator 31, a reception low-pass filter (LPF) 32, a frame synchronization mechanism 33, sampling parts 34, an equalizer 35, a decoder and other parts.

Operation of the transmitter and receiver 30 is described below.

The transmitter 10 converts input data bm to transmission symbols X =$\{x_1, x_2, ..., x_N\}$ through the encoder 11, controls the band width through the transmission low-pass filter, generates transmission complex base band signals s(t), modulates the transmission complex base band signals s(t) with carriers through the modulator 13 and transmits them as signals sc (t) to the transmission line 20.

The receiver 30 converts signals rc (t), which has passed through the transmission line 20, to complex base band signals r (t) through the demodulator 31 and obtains reception complex base band signals y (t) which are band-limited by the reception low-pass filter 32.

Then, a leading position (time) Et slot(k) of the time slot assigned to a subscriber is estimated according to these signals y(t) by the frame synchronization mechanism 33, and the reception signals y(t) are sampled by the sampling part 34 according to the following equation:

$$y = [y (Et \ slot \ (k) + \tau_1 + (n-1) \ T) ]$$

$$(n = 1, 2, ..., N) \qquad ... (1)$$

where,

ET slot (k): Estimated leading time of the kth assigned time slot (E means estimation.)
$\tau_1$: Fixed sampling phase
T: Symbol interval time

The characteristic of the transmission line 20 due to the frequency selective fading is compensated with the

sample value sequences $\mathbf{Y}$ of signals y(t) by the equalizer 35 and a transmission symbol is estimated.

Finally, estimated values $\mathbf{E}\mathbf{x}$ = {$E_{Xn}$} (n=1, 2, ..., N; E means estimation) are decoded by the decoder 36 and estimated values $Eb_m$ of the transmitted data are obtained.

The following describes the above described maximum likelihood sequence estimation which constitutes the equalizer.

As regards the maximum likelihood sequence estimation, reference is directed to "J. G. Proakis 'Digital Communications' (1983) New York: McGraw-Hill, p. 548-554, p. 610-648".

As disclosed in the above reference, the maximum likelihood sequence estimation is intended to estimate the transmission symbol sequence $\mathbf{x}$ = {x1, x2, .., xN) for which the probability (likelihood) of materialising the reception signals sequences $\mathbf{y}$ = {y1, y2, ..., yN) with the impulse response h(t) as known when the reception signal sequences $\mathbf{Y}$ = {y1, y2, ..., yN} in a certain range are obtained. This maximum likelihood sequence is obtained by, after all, obtaining the symbol sequence $\mathbf{x}$ = {x1, x2, ..., xN} in which the following value is maximised

$$-\sum_{k=1}^{N} \ | \ y_k - \sum_{j} \ x_j \ h \ (t \ -jT) \ |^2 \qquad\qquad (2)$$

if a white Gaussian noise is assumed as the noise of the transmission line.

Equation (2) is efficiently calculated by using the Viterbi algorithm which is known as a decoding method for the convolutional codes.

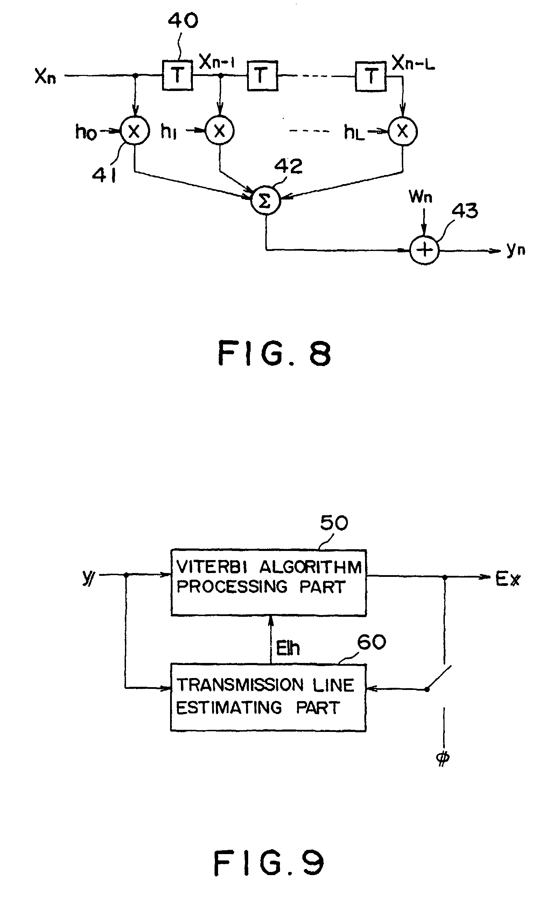

The following briefly describes the principle of the Viterbi algorithm applied to the maximum likelihood estimation while referring to Fig.8 which shows a model of the transmission path or transmission line.

The transmission line is assumed in a discrete time model in which the impulse responses shown in Fig.8 are limited. In Fig.8, numerals 40 denote a delay element with a symbol interval T, 41 is a multiplier, 42 is an accumulator and 43 is an adder.

|h ={hj}(j=0, ..., L) is a sample value h (t-jT) of impulse responses h(t) at the symbol interval T on the transmission line 20 including transmission and reception low-pass filters 12 and 32 and the lengths of the impulse responses are (L + 1)T. $W_n$ is the noise of the transmission line which is additive white Gaussian noise. According to this assumption, equation (2) is as given below.

$$-\sum_{k=1}^{N} \ | \ y_k - \sum_{j=0}^{L} \ x_{k-j} \ h_j \ |^2 \qquad\qquad (3)$$

Therefore, the sum $J_n$ up to k=n in equation (3) is given as below using the sum $J_{n-1}$ up to k=n-1.

$$J_n = J_{n-1} - | \ y_n - \sum_{j=0}^{L} \ x_{n-j} \ h_j \ |^2 \qquad\qquad (4)$$

In this case, $J_n$ is a value which is proportional to the logarithmic likelihood of the reception signal sequence up to k=1 to n and referred to as the "path-metric" value and the second term of the right side of equation (4) is a value which is proportional to the logarithmic likelihood as to the state transition (branch) and referred to as the "branch-metric" value.

On the other hand, the state of the transmission line model shown in Fig. 8 at timing n-1 is given by the following status vector.

$$Sn-1 = \{Xn-1, Xn-2, ..., Xn-L\} \qquad\qquad (5)$$

If there are M types of transmission symbols, $M^L$ types of states are available for the transmission line.

Assuming the transition from state $S_{n-1}$ at timing n-1 to state Sn at timing n, transitions from M types of states $S_{n-1}$ are available for each of $M^L$ types of states Sn. The state transition between these timings is referred to as "branch" and Mn types of paths which follow up the states are referred to as "path". There are the paths from M types of states as the preceding timing for each of $M^L$ types of available states at respective timings.

The Viterbi algorithm is for calculating the path-metric value of equation (4) with respect to M number of available paths in respective states at respective timings to select a path with the largest value. Accordingly $M^L$ types of paths are left at each timing and the past paths are gradually converged to one path. An estimated value of the transmission symbol sequence is obtained from the path which is finally converged.

Fig. 9 is a block diagram showing a configuration example of the conventional maximum likelihood sequence estimator.

This maximum likelihood sequence estimator consists of a Viterbi algorithm processing part 50 and a transmission line estimating part 60.

Reception signals y(t) are sampled according to equation (1) by the sampling parts when the kth assigned time slot is to be processed and entered into the Viterbi algorithm processing part 50 and the transmission line estimating part 60.

The transmission line estimating part 60 estimates impulse responses of the transmission line according to the adaptive algorithm such as LMS (Least Mean Square) from the host equipment, not shown, which provides information necessary for the sample value sequences y and the component units in the receiver 30 shown in Fig. 7 which corresponds to the sample value sequence by using the given training sequencer $\phi$ shown in Fig. 7 in the training sequence part of the time slot shown in Fig. 6 of the sample value sequences $\mathcal{y}$. In the sample value sequences $\mathcal{y}$ other than the training sequence part of the time slot shown in Fig. 6, the estimation of the impulse response of the transmission line is continues using the estimated value $\mathbf{E}\mathbf{x}$ of the transmission symbol sequence.

The estimated impulse responses Eh of the transmission line are entered into the Viterbi algorithm processing part.

The Viterbi algorithm processing part 50 estimates a transmission symbol according to the above described principle by using the impulse response Eh of the transmission lines which have been estimated as the sample value sequence $\mathcal{y}$ for reception signals.

However, the conventional maximum likelihood sequence estimator carries out simulation under the conditions that are applied in advance and fixes the sampling phase at a trade-off point which is determined by checking the bit error rate and therefore there is a problem that an optimum sampling phase where the bit error rate is minimised under all conditions is not established.

This is exemplified by GB-A-2 242 339 which discloses a circuit for estimating frame phase, which includes sampling means for sampling reception signals at a symbol interval or period (T) with respect to respective sampling phases of sampling phase sequences of the reception signals, correlation value calculating means for obtaining complex cross-correlation functions of the sample value sequences and training sequences of the sample value sequences, and selecting means for obtaining a selected sampling phase at which the absolute values of the complex cross-correlation functions are maximised, by comparing the absolute values.

Reference is also directed to EP-A-0 544 315 (Art. 54(3) EPC), which discloses a maximum likelihood sequence estimation apparatus having a plurality of samplers which sample an input signal at a constant pulse frequency in sequentially different sampling phases.

In addition, the conventional maximum likelihood sequence estimator has an accompanied problem that, if the number of interference waves and the delay time varies, the optimum sampling phase which minimises the bit error rate vary accordingly and moreover the deviation of the sample phase for the optimum sampling phase may cause deterioration of the bit error rate, which has proved to be a difficult problem to solve.

An object of the present invention is to provide a maximum likelihood sequence estimator capable of solving the above described problems.

According to the present invention, there is provided a maximum likelihood sequence estimator comprising sampling means for sampling reception signals y(t) from a transmission path, at a symbol interval T with respect to respective sampling phases of sampling phase sequences $\tau = \{\tau (i)\}$ (i = 1, 2, ..., M), to obtain sample value sequences $\mathcal{y}$ i = {yin} (i = 1, 2, ..., M; n = 1, 2, ..., Nt) of the reception signals y(t) correlation value calculating means for obtaining complex cross-correlation functions $\mathbb{C}$ = {Ci} (i = 1, 2, ..., M) of the sample value sequences $\mathcal{y}$i and training sequences $\phi$ = {$\phi$n} (n = 1, 2, ..., Nt) of the sample value sequences $\mathcal{y}$i, and selecting means for obtaining a selected sampling phase at which the absolute values of the number M of complex cross-correlation functions Ci are maximised by comparing the absolute values; a transmission path estimating part for obtaining estimated values E|h = {Ehj} (j = 0, 1, ... L,) of impulse responses of the transmission path according to an adaptive equalising algorithm with respect to the sample value sequences y and the corresponding training sequences $\phi$ thereto and from estimated values $\mathbf{E}\mathbf{x}$ of the transmission symbol sequences and the sample value sequences $\mathcal{y}$; and a Viterbi algorithm processing part for obtaining the estimated values $\mathbf{E}\mathbf{x}$ = {Exn} (n = 1, 2, ..., N) of transmission symbol sequences from the sample value sequences y based on the estimated values E|h, **characterised by** sample phase smoothing means for obtaining a sampling phase τs based on the selected sampling phase obtained by said selecting means such that the bit error rate is minimised, a sampling processing part for sampling the reception signals y(t) entered at specified timings with respect to a symbol interval T and the sampling phase τs to obtain sample value sequences $y$ = {yn} (n = 1, 2, ..., N).

According to the invention, there is also provided a maximum likelihood sequence estimating method comprising sampling reception signals y(t) from a transmission path, at a symbol interval T with respect to respective sampling phases of sampling phase sequences τ = {t (i)} (i = 1, 2, ..., M), to obtain sample value sequences $y_i$ = {yin} (i = 1, 2, ..., M; n = 1, 2, ..., Nt) of the reception signals y(t) obtaining complex cross-correlation functions $C$ = {Ci} (i = 1, 2, ..., M) of the sample value sequences y i and training sequences $\phi$ = {φn} (n = 1, 2, ..., Nt) of the sample value sequences $y_i$, and selecting a sampling phase at which the absolute values of the number M of complex cross-correlation functions Ci are maximised by comparing the absolute values, obtaining estimated values E|h = {Ehj} (j=0, 1, ... L), of impulse responses of the transmission path according to an adaptive equalising algorithm with respect to the sample value sequences $y$ and the corresponding training sequences $\phi$ thereto and from estimated values $Ex$ of the transmission symbol sequences and the sample value sequences y, and using the Viterbi algorithm to obtain the estimated values $Ex$ = {Exn} (n = 1, 2, ..., N) of transmission symbol sequences from the sample value sequences $y$ based on the estimated values E |h, characterised by obtaining a sampling phase τs based on the selected sampling phase such that the bit error rate is minimised, sampling the reception signals y(t) entered at specified timings with respect to a symbol interval T and the sampling phase τs to obtain sample value sequences $y$ = {yn} (n = 1,2,...,N).

A maximum likelihood sequence estimator in accordance with the present invention, described in more detail hereafter, for use with a transmission line, is provided with a sampling phase calculating part, a sampling processing part, a transmission line estimating part and a Viterbi algorithm processing part.

The sampling phase calculating part performs the function of sampling the reception signals y(t) from the transmission lines at the symbol interval T in respective sampling phases of the sampling phase sequence τ = {τ(i)} (i=1, 2, ..., M) by starting from the estimated leading time Et slot (k) of the time slot, obtaining the sample value sequences of M number of the above described different reception signals y(t) as shown below,

$$y\, i = \{Y(Et\ slot\ (k) + \tau\ (i) + (n\text{-}1)T\}$$

(i=1, 2, ..., M; n=1, 2,..., Nt)
calculating the complex cross-correlation functions $C$ ={Ci} (i=1, 2, ..., M) of the training sequences $\phi$ from the above sample value sequences y/ i and the training sequences $\phi$, comparing the absolute values of these M complex cross-correlation functions Ci, selecting a sampling phase τ($I_k$) where the absolute values are maximized and obtaining the specified sampling phase $\tau_s$ from calculation based on the selected sampling phase τ($I_k$).

The sampling processing part performs the function of sampling the above described reception signals y(t), which are entered at the specified timing, at the sampling phase $\tau_s$ and the symbol interval T, starting from the estimated leading time Et slot (k) and obtaining the sample value sequences $y$ = {$y_n$} (n=1, 2, ..., N) .

The transmission line estimating part has the function for obtaining the estimated value E |h = {Ehj} (j = 0, 1, ..., L) of impulse responses of the above transmission lines according to the adaptive equalizing algorithm with respect to the sample value sequences $y$ and the training sequences $\phi$ corresponding thereto and also the estimated value $Ex$ of the transmission symbol sequence and the sample value sequence $y$.

The Viterbi algorithm processing part has the function for obtaining the estimated values $Ex$ of the above described transmission symbol sequences from the sample value sequences $y$ according to the Viterbi algorithm on the basis of the above estimated value E |h.

The sampling phase calculating part may calculate complex cross-correlation functions C of the training sequence $\phi$ of the equaliser from the portions corresponding to the sample value sequences $y$ i and the training sequences $\phi$ of the equaliser for the sample value sequences with respect to individual sample value sequences $y$ i for reception signals y(t) which have been sampled in a plurality of different sampling phases. After a sampling phase τ(Ik) where the complex cross-correlation function $C_i$ is maximised has been selected, a sampling phase τs where the bit error rate is minimised is calculated through calculation based on the selected sampling phase τ(Ik) and given to the sampling process part.

The sampling process part sample reception signals y(t), which are entered at the specified timings, with the sampling phase τs and the symbol internal T to obtain the sample value sequence $y$ and sends it to the transmission line estimating part and the Viterbi algorithm processing part.

The transmission line estimating part functions to obtain estimated values E|h of impulse responses of the transmission line from the sample value sequences $\phi$ and the training sequences corresponding to the sample value sequences $y$ i in the training sequence part of the sampling value sequences $y$ i and estimated values E |h of impulse responses of the transmission lines by using the estimated values Ex of the sample value sequences $\underline{y}$ and the transmission symbol sequences for reception signals y(t) in the part other than the training sequences of the sampling value sequences $\underline{y}$ i, and the estimated values E|h obtained are given to the Viterbi algorithm processing part.

The Viterbi algorithm processing part functions to obtain the estimated values of the transmission symbol sequences Ex based on the estimated values E h of the impulse responses of the transmission lines.

Thus the present invention enables calculation of the sampling phases to be made simply and accurately where the bit error rate is estimated to be least from a plurality of different sampling phases and enable estimates to be made which provide a more precise transmission symbol sequence in which the bit error rate is improved.

Accordingly, the present invention also enables to solve the problem that the optimum sampling phase where the bit error rate is minimized under all conditions is not always established since the sampling phase is fixed as in the conventional case and also the problem, if the number of interference waves and the amount of delay differ, the optimum sampling phase where the bit error rate is minimised differs and moreover the deviation of the sampling phases from the optimum sampling phase causes deterioration of the bit error rate.

This example of the invention will now be described in more detail with reference to the accompanying drawings, in which:

Fig. 1 is a diagram showing a configuration of a maximum likelihood sequence estimator which is a first embodiment of the present invention;

Fig. 2 is a flow chart showing operation of a sampling processing part of the present invention;

Fig. 3 is a flow chart showing operation of a transmission line estimating part according to the present invention;

Fig. 4 is a Viterbi algorithm processing part according to the present invention;

Fig. 5 is a flow chart showing operation of a sampling phase calculating part according to a first embodiment of the present invention;

Fig. 6 is a diagram showing a frame configuration of TDMA scheme;

Fig. 7 is a diagram showing a configuration of a transmitter and a receiver for digital mobile telephony;

Fig.8 is a diagram showing a model of transmission line shown in Fig.7;

Fig.9 is a diagram showing a configuration of a conventional maximum likelihood sequence estimator;

Fig.10 is a sampling phase characteristic diagram when the amount of delay shown in Fig.1 is 0.25T (10µ sec);

Fig.11 is a sampling phase characteristic diagram when the amount of delay shown in Fig.1 is 1.00T (40µ sec) ;

Fig.12 is a diagram showing a configuration of a maximum likelihood sequence estimator according to a second embodiment of the present invention;

Fig.13 is a flow chart showing operation of a sampling phase calculating part according to a second embodiment of the present invention;

Fig.14 is a diagram showing a configuration of a maximum likelihood sequence estimator according to a third embodiment of the present invention;

Fig.15 is a flow chart showing operation of a sampling phase calculating part according to a third embodiment of the present invention;

Fig.16 is a diagram showing a configuration of a maximum likelihood sequence estimator according to a fourth embodiment of the present invention; and

Fig.17 is a flow chart showing operation of a sampling phase calculating part according to a fourth embodiment of the present invention.

First Embodiment

In the first embodiment of the present invention, a maximum likelihood sequence estimator for forming, for example, an equalizer 35 and sampling parts 34 in a receiver 30 shown in Fig.7 is described. The embodiment is described as to the case where a sampling phase τs which is estimated to provide the least bit error rate is calculated from the sequence τ = {τ (i)} (i=1, 2, ..., M) of simple non-increasing or simple non-decreasing sampling phases.

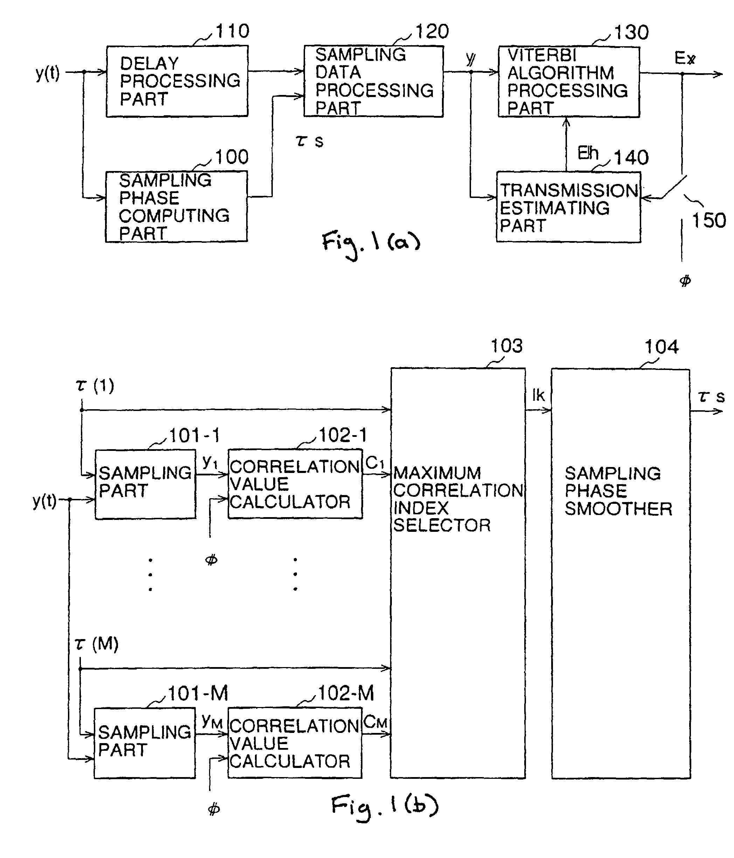

Fig.1 shows a configuration of a maximum likelihood sequence estimator which is an embodiment of the present invention and Fig.1 (a) a functional block diagram of the whole maximum likelihood sequence estimator and Fig.1 (b) is a functional diagram of the sampling phase calculating part shown in Fig.1 (a).

In Fig.1 (a), the maximum likelihood sequence estimator comprises a program control which employs a discrete circuit such as an integrated circuit or a processor. The maximum likelihood sequence estimator is provided with a sampling phase calculating part 100, a delay processing part 110, a sampling processing part 120, a Viterbi algorithm processing part 130 and a transmission line estimating part 140.

The sampling processing part 120 is connected to the output sides of the sampling phase calculating part 100 and the delay processing part 110. The Viterbi algorithm processing part 130 and the transmission line estimating part 140 are connected to the output side of sampling processing part 120.

6

The sampling phase calculating part 100 has the functions for sampling reception signals y(t) from the transmission line, calculating the specified sampling phase τs through calculations for sample value sequences i = {$y_{in}$} (i=1, 2, ..., M; n=1, 2, ..., Nt) and the training sequences SYNC ={φn} (n=1, 2, ..., Nt) and giving the sampling phase obtained to the sampling processing part 120.

The delay processing part 110 functions to give the reception signals y(t) which have been delayed as long as specified to the sampling processing part 120.

The sampling processing part 120 functions to obtain the sample value sequence = {$y_n$} (n = 1, 2, ..., N) by sampling reception signals y(t) from the delay processing part 110 with the sampling phase τs and the symbol interval T, starting from the estimated leading time Et slot (k) of the time slot when the assigned kth time slot is to be processed and gives it to the Viterbi algorithm processing part 130 and the transmission line estimating part 140.

The Viterbi algorithm processing part 130 functions to obtain the estimated values **Ex** = {Exn} (n = 1, 2, ..., L) of the transmission symbol sequence according to the principle of the Viterbi algorithm, which has conventionally been used, in accordance with the input of the sample value sequence and the estimated values E|h = {$Eh_j$} (j = 0, 1, ..., L) and comprises branch metric calculation means, path metric calculation means and others.

The transmission line estimating part 140 functions to obtain the estimated values E of the impulse responses of the transmission line from the sample value sequences and the training sequences corresponding thereto in the training sequence part of the time slot shown in Fig.6 of the sample value sequences and the estimated values E of the impulse responses by using the sample value sequences of reception signals y(t) and the estimated values Ex of the transmission symbol sequences in the part other than the training sequence part of the time slot shown in Fig.6 of the sample value sequences , and give the estimated values $Eh$ of impulse responses to the Viterbi algorithm processing part 130.

Switch means 150 functions to switch over the transmission line estimating part 140 to the training sequence when processing the training sequence part of the time slot shown in Fig.6 of the sample value sequences and to the estimated value Ex side of the transmission symbol sequences when processing the part other than the training sequence part and gives the switchover signals to the transmission line estimating part 140.

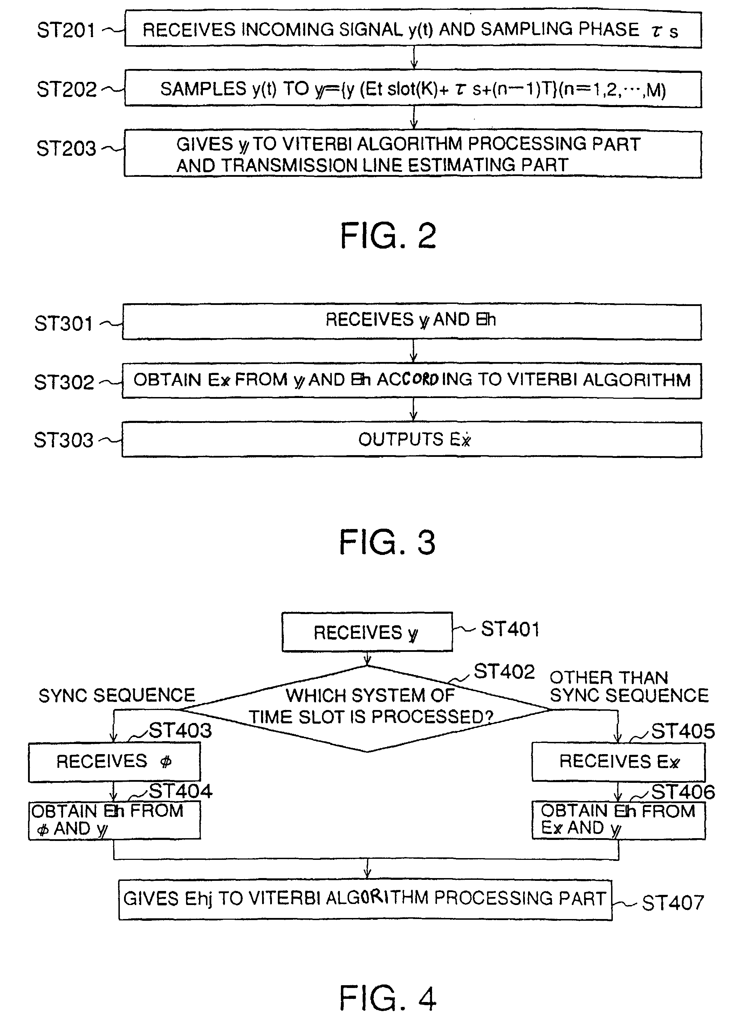

Fig.2 is a flow chart showing the operation of the sampling processing part, Fig.3 is a flow chart showing the operation of the Viterbi algorithm processing part and Fig.4 is a flow chart showing the operation of the transmission line estimating part.

The operation of the maximum likelihood sequence estimator in accordance with the present invention is described below referring to Figs.2, 3 and 4 and Fig.1(a).

Reception signals y(t) are entered into the sampling phase calculating part 100 and the delay processing part 110 for each assigned time slot.

For processing the kth assigned time slot, the sampling phase calculating part 100 samples reception signals at M number of different sampling phases τ (i) and the symbol interval T, starting from the estimated leading time Et slot (k) of the time slot. Subsequently, the sampling phase calculating part 100 calculates the complex cross-correlation functions of the part corresponding to the training sequences of the equalizer as given below.

$$\{y \ (Et \ slot \ (k) + τ \ (i) + (n - 1) \ T\}$$

(i = 1, 2, ..., M; n = 1, 2, ..., Nt)

and the training sequences φ of the equalizer of the sample value sequences are calculated for each i value. The sampling phase where the absolute value of this complex cross-correlation function is maximized is selected and the sampling phase τs calculated based on the calculated sampling phase is given to the sampling processing part 120.

On the other hand, reception signals y(t) entered into the delay processing part 110 are delayed until the sampling phase τs is selected by the sampling phase calculating part 100 and then entered into the sampling processing part 120.

The sampling processing part 120 receives the reception signals y(t) and the sampling phases τs (ST201) and, when processing the kth assigned time slot, samples reception signals y(t) according to the following equation (ST202),

$$y = \{y \ (Et \ slot \ (k) + τs + (n-1) \ T\}$$

$$(n = 1, 2, ..., N) \qquad\qquad (6)$$

where,

Et slot (k): Estimated leading time of the kth assigned time slot

$\tau$s: Sampling phase

T: Symbol interval time

and the sample value sequences $\underbar{y}$ are given to the Viterbi algorithm processing part 130 and the transmission line estimating part 140 (ST203).

The Viterbi algorithm processing part 130 functions to obtain the estimated values Ex from the sample value sequences from the sampling processing part 120 and the estimated values E (ST301) from the transmission line estimating part 140 according to the above described principle, and outputs the estimated values (ST303).

The transmission line estimating part 140 functions to obtain the estimated values E of the impulse responses of the transmission lines from the sample value sequences and the corresponding training sequences (ST403) thereto which are switched over and entered by switch means 150 according to the adaptive equalizing algorithm in the training sequence SYNC part of the time slot down in Fig.6 of the received sample value sequences (ST404) and give the estimated values to the Viterbi algorithm processing part 130 (ST407). In addition, the transmission line estimating part 140 functions to obtain the estimated values E of the impulse responses of the transmission lines (ST406) by using the sample value sequences of reception signals y(t) and the estimated values Ex (ST405) of the transmission symbol sequences (which are switched over and entered from switch means 150) and give the estimated values E to the Viterbi algorithm processing part 130 (ST407) in the part other than the training sequence part of the time slot shown in Fig.6 of the sample value sequences

The configuration of the sampling phase calculating part 100 is shown in Fig.1(b) which is a feature of the present invention.

This sampling phase calculating part 100 is provided with sampling parts 101-1~101-M which sample reception signals y(t) at the sampling phases of the above described sampling phase sequence $\tau$ and the symbol interval T, starting from the estimated leading time Et slot (k) of the time slot and obtain M number of sample value sequences i of reception signals y(t). A maximum correlation index selector 103 is connected to the output sides of sampling parts 101-1~101-M through the correlation value calculators 102-1~102-M.

The correlation value calculators 102-1~102-M function to calculate complex cross-correlation functions Ci (i=1, 2, ..., M) from the sample value sequence i and corresponding training sequences

The maximum correlation index selector 103 compares the absolute values of M complex cross-correlation functions Ci which are calculated by the correlation value calculators 102-1~102-M and selects the sampling phase $\tau$ ($I_k$) where the absolute values are maximized. In addition, the maximum correlation index selector functions to output the index $I_k$ of the selected sampling phase $\tau$ (Ik) as the index $I_k$ of the sampling phase which is selected when the kth sampling phase is selected, and a sampling phase smoother 104 is connected to the output side thereof.

The sampling phase smoother 104 functions to obtain the sectional weighted mean value, sectional maximum value and sectional minimum value of index $I_k$ selected by the maximum correlation index selector 103 and outputs the sampling phase $\tau_s$ corresponding to the index which is obtained by adding a value obtained by subtracting the sectional minimum value from the sectional maximum value and multiplying it by a constant to the sectional weighted mean value.

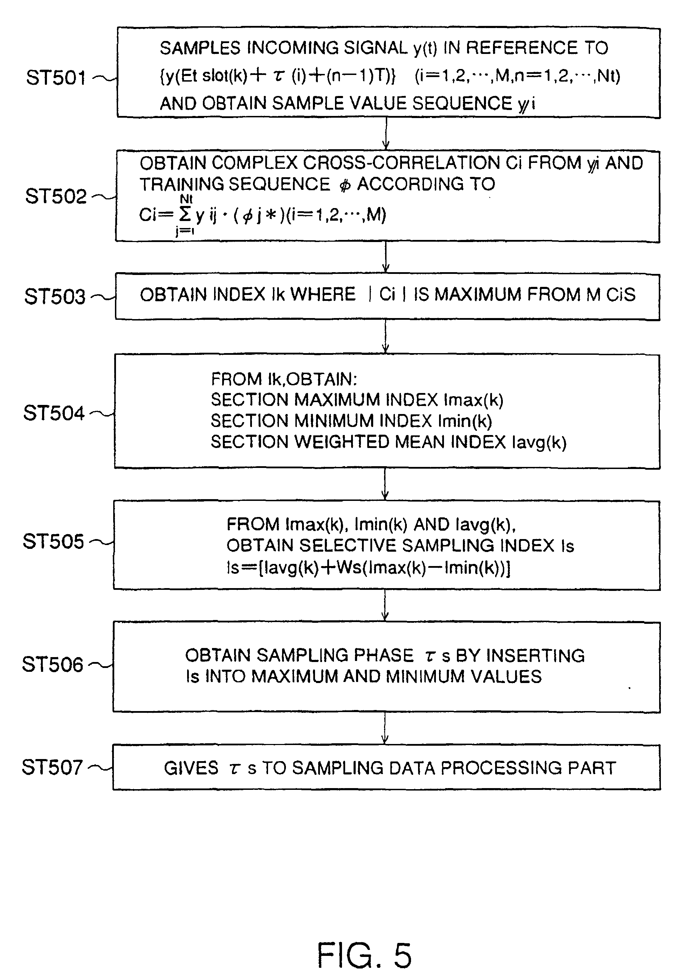

Fig.5 is a flow chart showing the operation of the sampling phase calculating part according to the first embodiment.

The operation of the sampling phase calculating part 100 is described below, referring to Figs.5 and 1(b).

Reception signals y(t) are entered for each assigned time slot and sampled in the sampling parts 101-1~101-M for every finite section according to the following equation when processing the kth assigned time slot and entered into the correlation value calculators 102-1~102-M (ST501).

$$i = \{y(Et \ slot \ (k) + \tau(i) = (n-1) \ T\}$$

$$(i = 1, 2, ..., M; n = 1, 2, ..., Nt) \tag{7}$$

The correlation value calculators 102-1~102-M calculate the complex cross-correlation functions $C_i$ of the sample value sequences i and corresponding training sequences of reception signals y(t) according to the equation (8) given below and gives these functions to the maximum correlation index selector 103 (ST502):

$$C_i = \sum_{j=1}^{Nt} y_{ij}\, (\phi_j^*) \quad (i = 1, 2, \ldots, M) \tag{8}$$

where, * means that complex conjugation is used.

The maximum correlation index selector 103 selects the sampling phase $\tau$ ($I_k$) where the absolute values of M complex cross-correlation functions $C_i$ are maximized and gives this index to the sampling phase smoother 104 as the index $I_k$ of the sampling phase which has been selected (ST504-ST507).

$$I\,max\,(k) = \begin{cases} \displaystyle \max_{1 \le j \le k} I_j & k < Ls \\[2mm] \displaystyle \max_{k - Ls + 1 \le j \le k} I_j & k \ge Ls \end{cases} \tag{9}$$

$$I\,min\,(k) = \begin{cases} \displaystyle \min_{1 \le j \le k} I_j & k < Ls \\[2mm] \displaystyle \min_{k - Ls + 1 \le j \le k} I_j & k \ge Ls \end{cases} \tag{10}$$

$$I\,avg\,(k) = \begin{cases} \dfrac{\displaystyle\sum_{i=1}^{k} \{W_a\,(k - j + 1)\, I_j\}}{\displaystyle\sum_{j=1}^{k} W_a\,(j)} & k < Ls \end{cases} \tag{11}$$

where,

$W_a\,(j)(j = 1, 2, \ldots, L_s)$ : Load coefficient
Ls; Maximum length of calculation

$$Is = [Iavg\,(k) + Ws\,(Imax\,(k) - Imin\,(k))] \tag{12}$$

where,

[ ]: Gaussian notation (The maximum integer which does not exceed a value in the notation is returned.)
$W_s$: Shift coefficient
$I_s$: Selection sampling phase index

$$\tau_s = \begin{cases} \tau(1) & Is < 1 \\ \tau(Is) & 1 \le Is \le M \\ \tau(M) & M < Is \end{cases} \qquad (13)$$

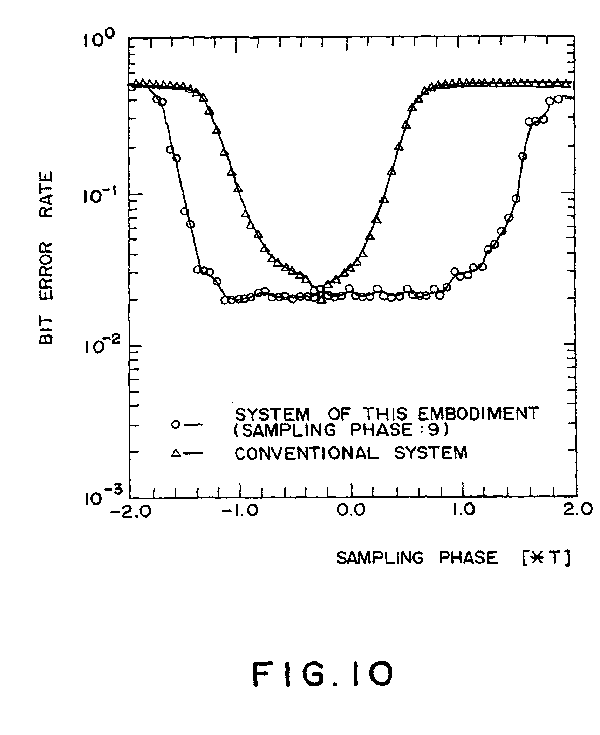

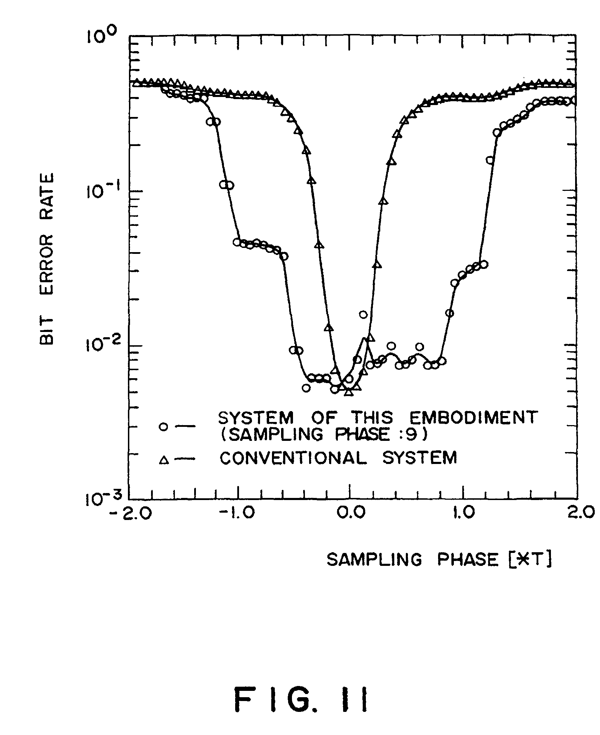

Figs.10 and 11 respectively show the results of simulation of the bit error rate in the case that this embodiment is applied. For this simulation, the frame configuration is of the North American Standard Digital Cellular Scheme shown in Fig.6 and the transmission line model is a 2-wave non-correlated Rayleigh fading model.

Fig.10 is a sampling phase characteristic diagram when the amount of delay shown in Fig.1 is 0.25T (10μ sec) and Fig.11 is a sampling phase characteristic diagram when the amount of delay shown in Fig.1 is 1.00T (40μ sec). The horizontal axes of Figs.10 and 11 denote the sampling phase deviation from the center of roll-off wave of a direct wave and the vertical axes denote the bit error rate (BER). From Figs.10 and 11, it is known that the bit error rate in the maximum likelihood sequence estimator of this embodiment when the sampling phase deviates from the optimum point is smaller than that in case of the conventional maximum likelihood sequence estimator.

Thus, in this embodiment, complex cross-correlation functions Ci for the training sequences of the equalizer of the parts {y (Et slot (k) + τ (i) + (n-1)T} (n = 1, 2, ..., Nt) corresponding to the training sequences of the sample value sequences i of reception signals y(t) are calculated by the correlation value calculators 102-1~102-M with respect to each of a plurality of different sampling phases τ (i) when the reception signals are sampled with the above described sampling phases. Samples phases $\tau_s$ are calculated from the sampling τ (i) where the complex cross-correlation function $C_i$ are maximized by the maximum correlation index selector 103 and the sampling phase smoother 104. Therefore the bit error rate (BER) can be improved better than in the embodiments according to the prior art.

Second Embodiment

In the second embodiment, there is described a maximum likelihood sequence estimator for forming, for example, the equalizer 35 and the sampling parts 34 in the receiver 30 shown in Fig.7. The following describes an embodiment when the sampling phase τs where the bit error rate is minimized is calculated from simple non-increasing or simple non-decreasing sampling phase sequences τ = {τ (i)} (i = 1, 2, ..., M).

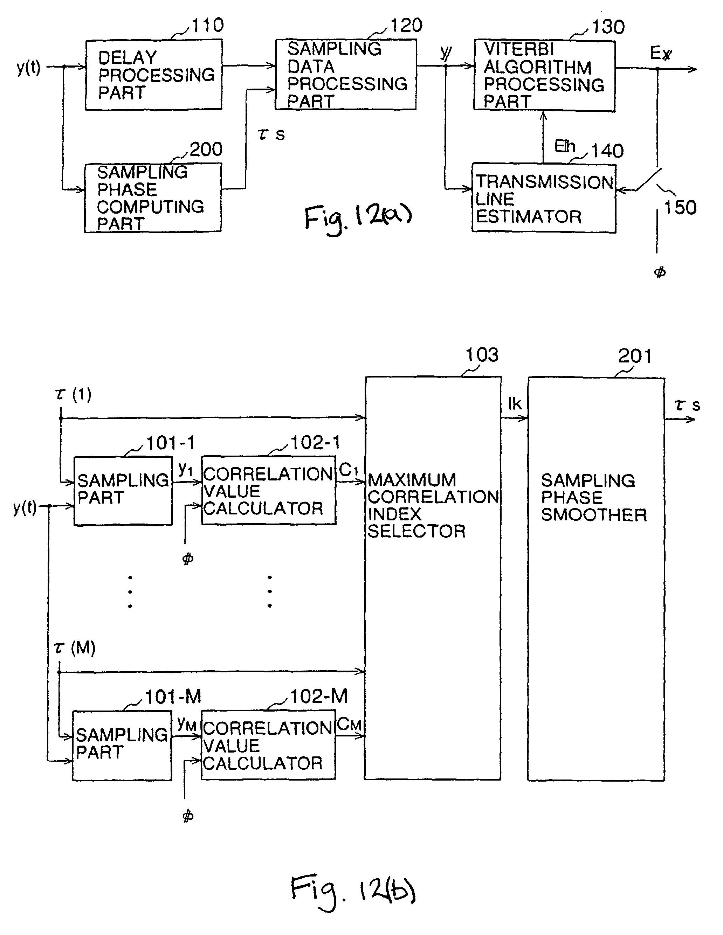

Fig.12 shows a configuration of a maximum likelihood sequence estimator which is the second embodiment of the present invention. Fig.12 (a) shows a functional block diagram of the whole sampling phase calculating part and Fig.12(b) is a functional block diagram of the sampling phase calculating part shown in Fig.12(a). In this case, the same components as those of the first embodiment are given the same symbols thereof.

The second embodiment differs from the first embodiment only in the configuration of the sampling phase smoother in the sampling phase calculating part. The configuration of the sampling phase smoother 201 in the sampling phase calculating part 200 which is the second embodiment is described below, referring to Fig.12(b).

The sampling phase smoother 201 functions to obtain the weighted mean value, a maximum value and a minimum value of the index $I_k$ selected by the maximum correlation index selector 103 and outputting a sampling phase $\tau_s$ corresponding to the index $I_k$ obtained by subtracting the minimum value from the maximum value, multiplying it by an α constant and adding the value obtained to the weighted mean value.

Other elements of the second embodiment shown in Fig.12 are the same as that of the first embodiment and therefore the description is omitted.

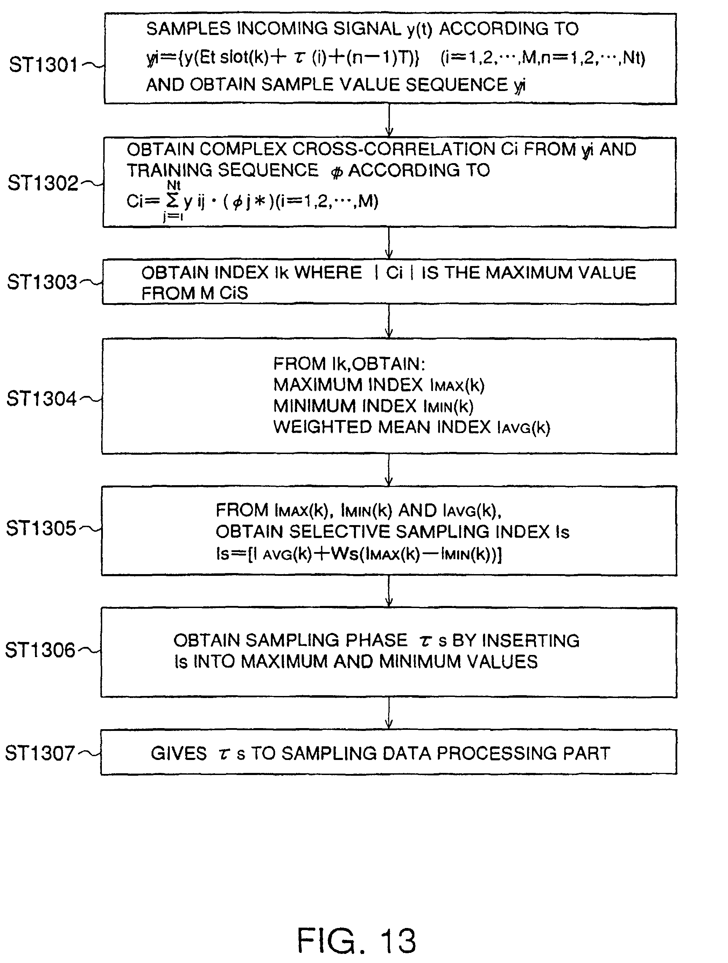

Fig.13 is a flow chart showing the operation of the sampling phase calculating part of the second embodiment according to the present invention.

The operation of the sampling phase calculating part 200 is described below, referring to Fig.12 (b) and Fig.13.

The sampling phase calculator 200 according to the second embodiment, as in the first embodiment, obtains complex cross-correlation functions Ci (i = 1, 2, ..., M) from reception signals y(t) and training sequences through the sampling parts 101-1~101-M and the correlation value calculating parts 102-1~102-M and gives these functions to the maximum correlation index selector 103 (ST1301, ST1302).

When the index $I_k$ is supplied from the maximum correlation index selector 103 to the sampling phase smoother 201 (S1303), the sampling phase smoother 201 outputs the sampling phase τs obtained from the above described equations (12) and (13) and the following equations (14)~(17) at the time of selection of the kth sampling phase (ST1304~ST1307).

$$I\,MAX\,(k) = \max I_j \qquad (14)$$

$$1 \le j \le k$$

$$I\ MIN\ (k) = \max I_j \tag{15}$$

$$1 \le j \le k$$

$$I\ AVG\ (k) = (1-\alpha)\ I\ AVG\ (k-1) + I_k \tag{16}$$

where, $\alpha$): constant

$$I\ AVG\ (o) = 0 \tag{17}$$

The second embodiment described above enables to provide the almost same effects as the first embodiment and speed up the estimation processing because a volume of calculation in the sampling phase smoother 201 is small.

Third Embodiment

The third embodiment describes a maximum likelihood sequence estimator for forming the equalizer 35 and the sampling part 34 in, for example, the receiver 30 shown in Fig.7. The embodiment is described with respect to a case for calculating a sampling phase $\tau_s$ where the bit error rate is estimated to be minimum from an optional sampling phase sequence $\tau = \{\tau\ (i)\}$ (i = 1, 2. ..., M).

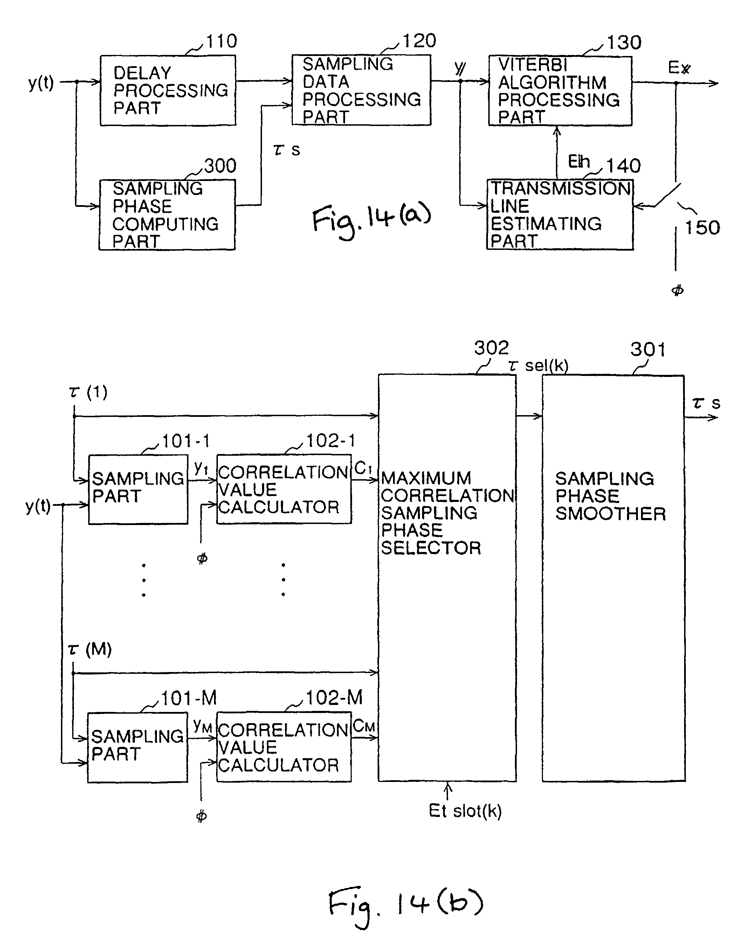

Fig.14 shows a configuration of a maximum likelihood sequence estimator which is the third embodiment of the present invention and Fig.14 (a) is a functional block diagram of the maximum likelihood sequence estimator and Fig.14 (b) is a functional block diagram of the sampling phase calculating part of the sampling phase calculating part shown in Fig.14 (a). In this case, the same components of the first embodiment are given the same symbols.

In the third embodiment, the internal configuration of the sampling phase calculating part differs from that of the first embodiment. The following describes the configuration of the sampling phase calculating part 300, referring to Fig.14 (b). In Fig.14 (a), the sampling phase calculating part 300 is provided with sampling parts 101-1~101-M which sample reception signals y (t) at respective sampling phases of the sampling phase sequences $\tau = \{\tau\ (i)\}$ (i = 1, 2, ..., M) and the symbol interval T as the symbol time, starting from the estimated leading time Et slot (t) of the time slot and obtain M number of different sample value sequences $\mathbf{y}i = \{y_{in}\}$ (i = 1, 2, ..., M; n = 1, 2, ..., Nt) of reception signals. The maximum correlation sampling phase selector 302 is connected to the output sides of sampling parts 101-1~101-M through the correlation value calculators 102-1~102-M.

The correlation value calculators 102-1~102-M function to calculate complex cross-correlation functions $C_i$ (i = 1, 2, ..., M) of the sample value sequences $\mathbf{y}_i$ and the training sequence SYNC $\phi = \{\phi\ n\}$ (n = 1, 2, ..., Nt).

The maximum correlation sampling phase selector 302 functions to compare the absolute values of M number of complex cross-correlation functions $C_i$ calculated by the correlation value calculators 102-1~102-M, select a sampling phase $\tau$ sel (k) where the absolute values of the correlation value functions are maximized and output the selected sampling phase, and the sampling phase smoother 301 is connected to the output sides of the correlation value calculators.

The sampling phase smoother 301 functions to obtain a coordinate transformation term tc (k) for transforming the sampling phase to the coordinates in reference to the input timing of reception signals when the frame synchronization is established in accordance with the estimated leading time Et slot (k) from the frame synchronization mechanism. The sampling phase smoother 301 functions to obtain the sectional weighted mean value, the sectional maximum value and the sectional minimum value after adding the coordinate transformation term tc (k) to the sampling phase $\tau$ sel (k) selected by the maximum correlation sampling phase selector 302, add a value obtained by subtracting the absolute values of the sectional minimum value and the coordinate transformation term tc (k) from the sectional maximum value and multiplying it by a constant to the sectional weighted mean value and output the sampling phase $\tau_s$ obtained by subtracting the coordinate transformation term tc (k) from the resultant value..

Another configuration of the third embodiment shown in Fig.14 is the same as that of the first embodiment and therefore the description is omitted.

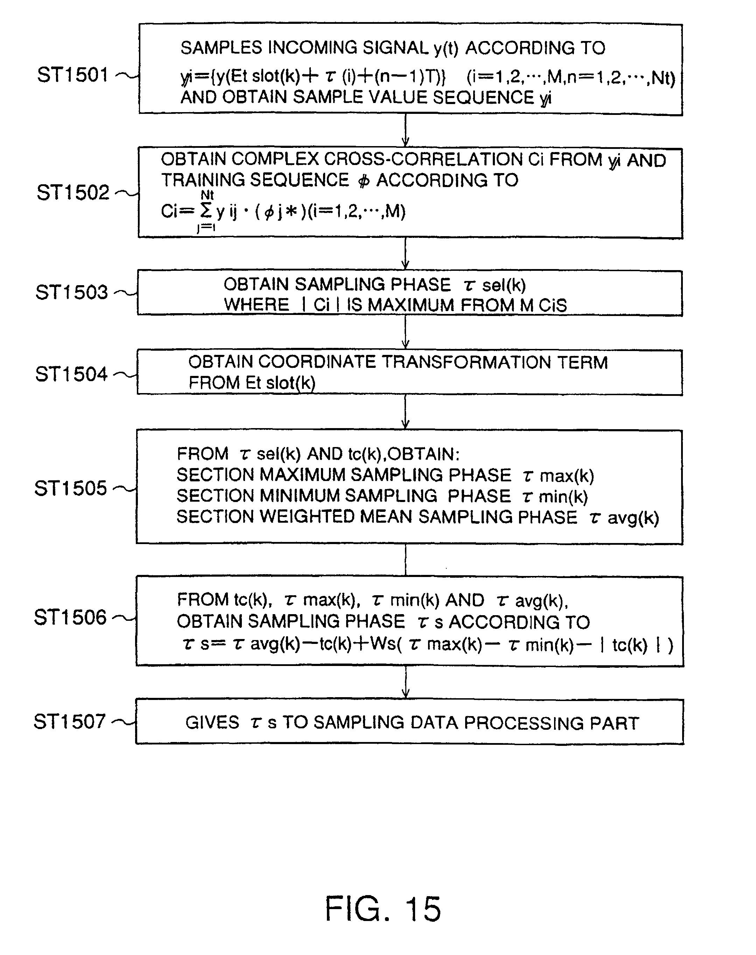

Fig.15 is a flow chart showing the operation of the sampling phase calculating part according to the third embodiment of the present invention.

The operation of the sampling phase calculating part 300 is described below, referring to Figs.15 and 14(b).

Reception signals are entered for each assigned time slot and sampled by the sampling parts 101-1~101-M according to equation (7) when the kth assigned slot is processed, then entered respectively into the correlation value calculators 102-1~102-M (ST1501).

Each of correlation value calculators 102-1~102-M calculates complex cross-correlation functions $C_i$ of the sample value sequences $y_i$ and corresponding training sequences $\phi$ of reception signals y(t) according to equation (8) and gives the functions obtained to the maximum correlation sampling phase selector 302 (ST1502).

The maximum correlation sampling phase selector 302 selects a sampling phase $\tau$ sel (k) where the absolute values of M number of cross-correlation functions $C_i$ are maximized and gives the selected sampling phase to the sampling phase smoother 301 as the sampling phase $\tau$ sel (k) when the kth sampling phase is selected (ST1504).

The sampling phase smoother 301 outputs the sampling phases $\tau_s$ obtained according to the following equations (18)~(23) (ST1504~ST1507).

$$\Delta tc\ (k) = Et\ slot\ (k) - Et\ slot\ (k-1)$$

$$k > 1 \tag{18}$$

$$tc\ (k) = \begin{cases} \sum_{i=1}^{k=1} \Delta tc\ (k) & k > 1 \\ \\ 0 & k = 1 \end{cases} \tag{19}$$

$$\tau\ max(k) = \begin{cases} max\ (\tau\ sel(j) + tc(j)) & k < Ls \\ 1 \le j \le k & \\ max\ (\tau\ sel(j) + tc(j)) & k \ge Ls \\ k - Ls + 1 \le j \le k & \end{cases} \tag{20}$$

$$\tau\ min(k) = \begin{cases} min\ (\tau\ sel(j) + tc(j)) & k < Ls \\ 1 \le j \le k & \\ min\ (\tau\ sel(j) + tc(j)) & k \ge Ls \\ k - Ls + 1 \le j \le k & \end{cases} \tag{21}$$

$$\tau \ avg(k) \ = \ \begin{cases} \dfrac{\displaystyle\sum_{j=1}^{k} \ \{wa \ (k-j+1)(\tau \ sel(j)) \ + \ tc \ (j)) \ \}}{\displaystyle\sum_{j=1}^{k} \ wa \ (j)} & k \ \geq \ Ls \\[30pt] \dfrac{\displaystyle\sum_{j=k-Ls+1}^{k} \ \{wa \ (k-j+1)(\tau \ sel(j)) \ + \ tc \ (j)) \ \}}{\displaystyle\sum_{j=1}^{Ls} \ Wa \ (j)} & k \ \geq \ Ls \end{cases} \tag{22}$$

$$\tau_s = \tau \ avg(k) - tc \ (k) + W_s \ (\tau \ max(k)) - \tau \ min(k)$$

$$- \ | \ tc \ (k) \ | \ ) \tag{23}$$

where,

$W_s$: Shift coefficient
$W_a$ (j) (j-1, 2, ..., $L_s$): Weighted coefficient
$L_s$: Maximum calculated length

Fourth Embodiment

In the fourth embodiment, there is described a maximum likelihood sequence estimator for forming the equalizer 35 and sampling parts 34 in a receiver 30 as shown, for example, in Fig.7. In this case, the embodiment is described with respect to the case for calculating a sampling phase $\tau_s$, where the bit error rate is minimized, from optional sampling phase sequences $\tau=\{ \tau \ (i) \}$ (i = 1, 2, ..., M).

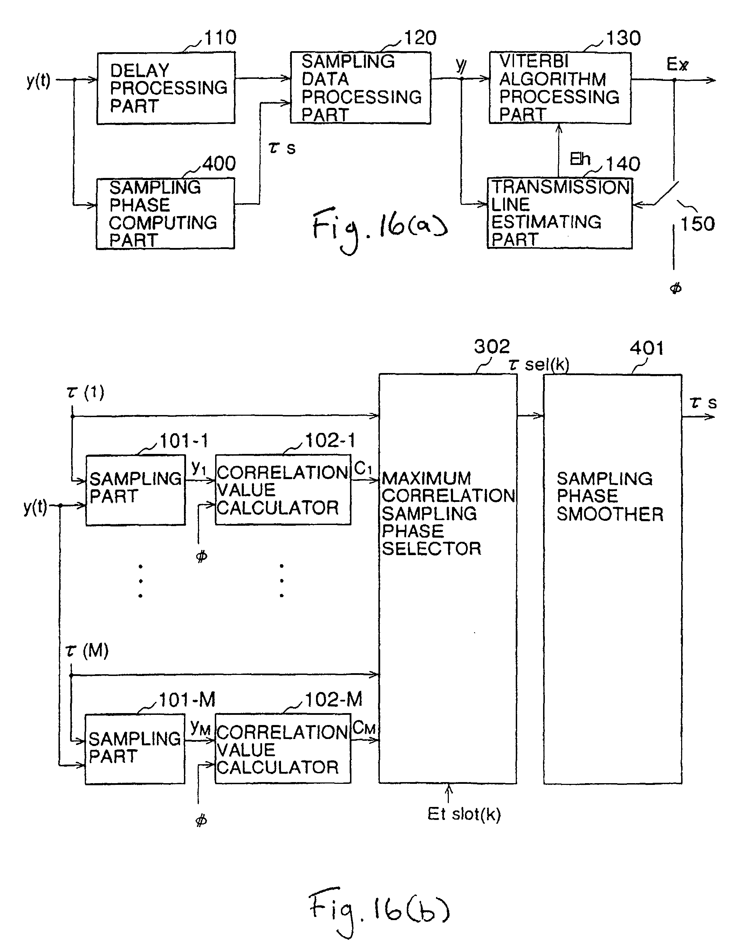

Fig.16 shows a configuration of the maximum likelihood sequence estimator which is the fourth embodiment according to the present invention, and Fig.16 (a) is a functional block diagram of the whole maximum likelihood sequence estimator and Fig.16 (b) is a functional block diagram of a sampling phase calculating part shown in Fig.16 (a). The same components as those of the third embodiment are given the same symbols.

The fourth embodiment differs from the third embodiment in that the configuration of the sampling phase smoother in the sampling phase calculating part differs from that of the third embodiment. The configuration of the sampling phase smoother 401 in the sampling phase calculating part 400 of the fourth embodiment is described below, referring to Fig.16 (b).

The sampling phase smoother 401 functions to obtain a first coordinate transformation term t c1 (k) and a second coordinate transformation term t c2 (i, k) for transforming the sampling phase to the coordinates in reference to the input timing of reception signals in frame synchronization at a current time in accordance with the estimated leading time ET slot (k) from the frame synchronization mechanism 33 (refer to Fig.7). The sampling phase smoother 401 functions to obtain the sectional weighted mean value, the sectional maximum value and the sectional minimum value after adding the second coordinate transformation term t c2 (j, k) to the sampling phase $\tau$ sel (k) selected by the maximum correlation sampling phase selector 302 and output the sampling phase $\tau$s obtained by adding a value, which is obtained by subtracting the absolute values of the sectional minimum value and the first coordinate transformation term t c1 (k) from the sectional maximum value and multiplying it by a constant, to the sectional weighted mean value.

Another configuration of the fourth embodiment shown in Fig.16 is the same as that of the third embodiment and therefore the description is omitted.

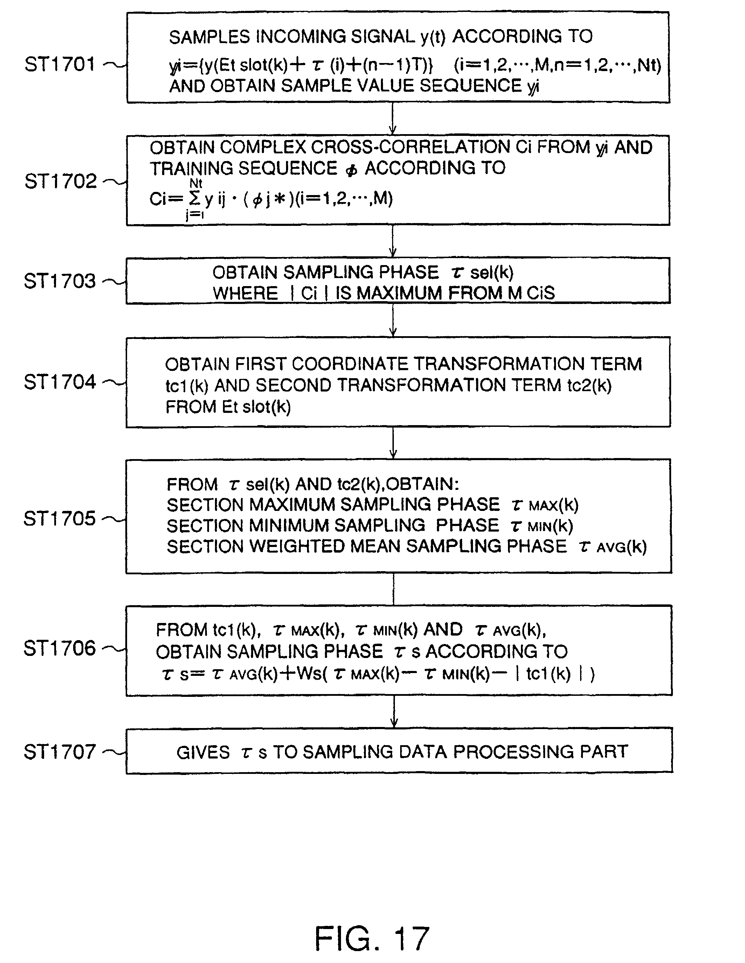

Fig.17 is a flow chart showing the operation of the sampling phase calculating part according to the fourth embodiment of the present invention.

The operation of the sampling phase calculating part 400 is described below, referring to Figs.17 and 16(b).

The sampling phase calculating part 400 of the fourth embodiment, as in the first embodiment, functions to obtain complex cross-correlation functions $\mathbb{C} = \{Ci\}$ (i = 1, 2, ..., M) from the reception signals y(t) and training sequences $\phi$ by the sampling parts 101-1~101-M and the correlation value calculators 102-1~102-M and give these functions to the maximum correlation sampling phase selector 302 (ST1701, ST1702).

When the maximum correlation sampling phase selector 302 selects a sampling phase $\tau$ sel (k) where the absolute values of correlation functions $C_i$ are maximized and gives this selected sampling phase to the sampling phase smoother 401 as the sampling phase $\tau$ sel (k) which is selected in the kth selection of the sampling phase (ST1703), the sampling-phase smoother 401 outputs the sampling phase $\tau_s$ obtained according to the following equations (24) ~ (30) in the kth calculation of the sampling phase (ST1704~ST1707).

$$\Delta\ tc\ (k)\ =\ \begin{cases} \text{Et slot (k) - Et slot (k-1)} & k > 1 \\ \\ 0 & k \le 1 \end{cases} \qquad \ldots(24)$$

$$\Delta\ tc1\ (k)\ =\ \begin{bmatrix} 0 & k \le 1 \\ \sum_{i=1}^{k-1} \Delta\ tc\ (i+1) & k < Ls \\ \sum_{i=1}^{k-1} \Delta\ tc\ (i+1) & k \ge Ls \end{bmatrix} \qquad \ldots (25)$$

$$\Delta\ tc1\ (k)\ =\ \begin{bmatrix} \sum_{i=j}^{k-1} \Delta\ tc\ (i+1) & j < k \\ \\ 0 & j \ge k \end{bmatrix} \qquad \ldots (26)$$

$$\tau\ MAX\ (k)\ =\ \begin{bmatrix} \max_{1 \le j \le k} (\tau\ \text{sel}\ (j)\ +\ tc2\ (j,k)) & k < Ls \\ \\ \max_{k-Ls+1 \le j \le k} (\tau\ \text{sel}\ (j)\ +\ tc2\ (j,k)) & k \ge Ls \end{bmatrix} \qquad \ldots (27)$$

$$\tau \ \text{MIN}(k) = \begin{cases} \max_{1 \le j \le k} (\tau \, \text{sel}(j) + tc2(j,k)) & k < Ls \\[2ex] \max_{k - Ls + 1 \le j \le k} (\tau \, \text{sel}(j) + tc2(j,k)) & k \ge Ls \end{cases} \qquad \ldots (28)$$

$$\tau \, \text{MAX}(k) = \begin{cases} \dfrac{\displaystyle\sum_{j=1}^{k-1} Wa(k - j + 1)(\tau \, sel(i) + tc2(j, k))}{\displaystyle\sum_{j=1}^{k} Wa(j)} & k < Ls \\[4ex] \dfrac{\displaystyle\sum_{j=k-Ls+1}^{k} Wa(k - j + 1)(\tau \, sel(i) + tc2(j, k))}{\displaystyle\sum_{j=1}^{Ls} Wa(j)} & k < Ls \end{cases} \qquad (29)$$

$$\tau s = \tau AVG(k) + ws(\tau MAX(k) - \tau MIN(k) - |t\,c1(k)|) \qquad (30)$$

where,

$W_s$: Shift coefficient
$W_a$: (j) (j = 1, 2, ..., $L_s$); Weighted coefficient
$L_s$: Maximum calculation length

The reference point of the sampling phase selected in respective time slots according to timing compensation by the frame synchronization mechanism differs with each time slot. In calculation in the first embodiment for which the above point is not taken into account, the bit error rate in calculation for obtaining the sampling phase $\tau_s$ may be adversely affected but, in the third and fourth embodiments, an adverse effect on calculation for obtaining the sampling phase $\tau_s$ can be prevented.

The present invention is not limited to the above described embodiments and is available in various modifications. Examples of such modifications are as shown below.

(i) A matching filter and a matching filter for whitening can be added to the configurations as the maximum likelihood sequence estimator shown in, for example, Figs.1, 12, 14 and 16 and the output of this whitening filter can be entered into the Viterbi algorithm processing part 130. These configurations differ only in the arithmetic equations for path-metric values and therefore the above described embodiments can be similarly applied to the maximum likelihood sequence estimators with those configurations.

(ii) The sampling phase selecting parts described in respective embodiments can be composed of the circuits other than shown in Figs.1 (b), 12 (b), 14 (b) and 16 (b). In addition, the embodiments are adapted to obtain the estimated values of transmission symbols by using the TDMA frame configuration shown in Fig.6 but the above embodiments can be applied using other data sequences.

The embodiments of the present invention described above are for use in land mobile communications equipment such as cordless telephone systems, automobile telephone systems, portable telephone systems, pocket type bells, simple land radio telephone systems, teleterminal systems, etc., maritime mobile communications equipment such as maritime mobile radio telephone systems, maritime satellite communications systems or aeronautical mobile communications systems such as airborne public telephone, etc.

In addition, the present invention is also adapted for use in radio mobile telephone systems which are used by various public organizations, MCA land mobile radio communications systems, self-defense communications systems for taxi radio communications, specific small power radio stations and others.

**Claims**

1. A maximum likelihood sequence estimator comprising:

sampling means (101-1, 101-M) for sampling reception signals y(t) from a transmission path, at a symbol interval T with respect to respective sampling phases of sampling phase sequences $\tau = \{\tau(i)\}$ (i = 1, 2, ..., M), to obtain sample value sequences $\mathcal{Y}i = \{yin\}$ (i = 1, 2, ..., M; n = 1, 2, ..., Nt) of the reception signals y(t)

correlation value calculating means (102-1, 102M) for obtaining complex cross-correlation functions $\mathcal{C} = \{Ci\}$ (i = 1, 2, ..., M) of the sample value sequences $\mathcal{Y}i$ and training sequences $\mathcal{Ø} = \{\phi n\}$ (n - 1, 2, ..., Nt) of the sample value sequences $\mathcal{Y}i$, and

selecting means (103, 302) for obtaining a selected sampling phase at which the absolute values of the number M of complex cross-correlation functions Ci are maximised by comparing the absolute values;

a transmission path estimating part (140) for obtaining estimated values $E|h = \{Ehj\}$ (j = 0, 1, ... L,) of impulse responses of the transmission path according to an adaptive equalising algorithm with respect to the sample value sequences $\mathcal{Y}$ and the corresponding training sequences $\mathcal{ø}$ thereto and from estimated values $E\mathcal{x}$ of the transmission symbol sequences and the sample value sequences $\mathcal{Y}$; and

a Viterbi algorithm processing part (130) for obtaining the estimated values $E\mathcal{x} = \{Exn\}$ (n = 1, 2, ..., N) of transmission symbol sequences from the sample value sequences $\mathcal{Y}$ based on the estimated values E|h, **characterised by**

sample phase smoothing means (104, 201, 301, 401) for obtaining a sampling phase $\tau s$ based on the selected sampling phase obtained by said selecting means such that the bit error rate is minimised,

a sampling processing part (120) for sampling the reception signals y(t) entered at specified timings with respect to a symbol interval T and the sampling phase $\tau s$ to obtain sample value sequences $\mathcal{Y} = \{yn\}$ (n = 1, 2, ..., N).

2. A maximum likelihood sequence estimator as set forth in claim 1, wherein:

said selecting means (103) is configured to obtain an index Ik from the selected sampling phase designated $\tau(Ik)$, and

said sampling phase smoothing means (104) is arranged to obtain a weighted means value, a maximum value and a minimum value of the index Ik, and to obtain an index Is by subtracting the minimum value from the maximum value to obtain a first resultant value, multiplying the first resultant value by a constant to obtain a second resultant value, and adding the second resultant value to the weighted mean value, the sampling phase $\tau_s$ corresponding to the index Is.

3. A maximum likelihood sequence estimator as set forth in claim 2, wherein said sampling phase smoothing means (104) is operable to obtain a weighted mean value, a maximum value and a minimum value of the index Ik every predetermined section.

4. A maximum likelihood sequence estimator as set forth in claim 2 or 3, wherein:

said sampling means (101) is configured to sample the reception signals y(t) at a symbol interval T with respect to respective sampling phases of simple non-increasing or simple non-decreasing sampling phase sequences $\tau = \{\tau(i)\}$ (i = 1, 2, ..., M) to obtain the sample value sequences $\mathcal{y}i$, and

said correlation value calculating means (102) is operable to obtain the complex cross-correlation functions Ci of the training sequences $\mathcal{ø}$ according to the following equation

$$Ci = \sum_{j=1}^{Nt} yij(\Phi j^*)$$

(where, i = 1, 2, ..., M: * means that complex conjunction is used).

5. A maximum likelihood sequence estimator as set fort in claim 4 wherein:

said sampling phase smoothing means (104) is arranged to obtain

(1) the weighted means value, maximum value and minimum value of the index Ik for every predetermined section respectively as a sectional weighted mean value I avg (k), a sectional maximum value I max (k) and a sectional minimum value I min (k) of the index Ik, calculated according to the following equations at the time of the kth sampling phase selection:

$$Imax(k) = \begin{cases} \max_{1 \le j \le k} Ij & k < Ls \\ \max_{k-Ls+1 \le j \le k} Ij & k \ge Ls \end{cases}$$

$$Imin(k) = \begin{cases} \min_{1 \le j \le k} Ij & k < Ls \\ \min_{k-Ls+1 \le j \le k} Ij & k \ge Ls \end{cases}$$

$$Iavg(k) = \begin{cases} \dfrac{\sum\limits_{j=1}^{k} \{wa(k-j+1)\,Ij\}}{\sum\limits_{j=1}^{k} wa(j)} & k < Ls \\[20pt] \dfrac{\sum\limits_{j=k-Ls+1}^{k} \{wa(k-j+1)\,Ij\}}{\sum\limits_{j=1}^{Ls} wa(j)} & k \ge Ls \end{cases}$$

(where, wa (j) (j = 1, 2, ..., Ls) is a weighted coefficient and Ls denotes the maximum length of calculation),
(2) a selective sampling phase index Is according to the following equation:

$$Is = [I\,avg(k) + ws(I\,max(k) - I\,min(k))]$$

(where, [ ] indicates the Gaussian notation which returns the largest integer not exceeding a value in the notation and ws denotes a shift coefficient),
and
(3) the sampling phase $\tau s$ corresponding to the index Is according to the following equation:

$$\tau s = \begin{cases} \tau\ (1) & Is < 1 \\ \tau\ (Is) & 1 \le Is \le M \\ \tau\ (M) & M < Is. \end{cases}$$

6. A maximum likelihood sequence estimator as set forth in claim 4 wherein:

said sampling phase smoothing means (104) is arranged to obtain

(1) the weighted mean value, maximum value and minimum value of the index Ik for every predetermined section respectively as a weighted means value I AVG (k), a maximum value I MAX (k) and a minimum value I MIN (k) of the index Ik, calculated according to the following equations at the time of the kth sampling phase selection:

$$I\ MAX(k) = \max_{1 \le j \le k} Ij$$

$$I\ MIN(k) = \min_{1 \le j \le k} Ij$$

$$I\ AVG(k) = (1 - \alpha)\ I\ AVG\ (k - 1) + \alpha Ik\ (\alpha: constant)$$

$$I\ AVG(O) = 0$$

(2) a selective sampling phase index Is according to the following equation:

$$Is = [I\ AVG\ (k) + ws\ (I\ MAX\ (k) - I\ MIN\ (k))]$$

(where, [ ] indicates the Gaussian notation which returns the largest integer not exceeding a value in the notation and ws denotes a shift coefficient),
and
(3) the sampling phase $\tau s$ corresponding to the index Is according to the following equation:

$$\tau s = \begin{cases} \tau\ (1) & Is < 1 \\ \tau\ (Is) & 1 \le Is \le M \\ \tau\ (M) & M < Is. \end{cases}$$

7. A maximum likelihood sequence estimator as set forth in claim 5 or 6, further comprising a delay processing part (110) for delaying the reception signals entered from the transmission lines as long a specified and outputting the signals to said sampling processing part, wherein:

said sampling processing part (120) is operable to sample the reception signals from said delay processing part,

said transmission estimating part (140) is arranged to obtain first estimated values E|h = {Ehj} (j = ), 1, ..., L) of the impulse responses of the transmission lines from the sample value sequences $y_l$ and training sequences $\phi$ corresponding to the sample value sequences $Y_l$, according to an adaptive equalisation algorithm,

said transmission estimating part (140) is arranged to obtain second estimated values E h from the sample value sequences $y_l$ and the estimated values $Ex$ = {Exn} (n = 1, 2, ..., N) of the transmission symbol sequences according to the adaptive equalisation algorithm, and

said operation processing part (130) is operable to obtain the estimated values $Ex$ according to a Viterbi algorithm.

8. A maximum likelihood sequence estimator as set forth in claim 1, wherein said sampling phase smoothing means (301) is arranged to obtain a sectional weighted mean value, a sectional maximum value and a sectional minimum value, all of a sampling phase $\tau sel(k)$ obtained as the selected sampling phase by said selecting means, and to obtain the sampling phase $\tau s$ based on the sectional weighted mean value, the sectional maximum value and the sectional minimum value.

9. A maximum likelihood sequence estimator as set forth in claim 8, wherein:

said sampling means (101) is arranged to sample the reception signals at the symbol interval T, starting from an estimated leading time determined by a frame synchronisation mechanism,

said sampling phase smoothing means is arranged to obtain a coordinate transformation term in accordance with the estimated leading time, add the coordinate transformation term to the sampling phase $\tau sel(k)$, obtain the sectional weighted mean value, a sectional maximum value and a sectional minimum value of the sampling phase $\tau sel(k)$ after adding the coordinate transformation term to the sampling phase $\tau sel(k)$, and to calculate the sampling phase $\tau s$ by respectively subtracting from and adding to the sectional weighted mean value, the coordinate transformation term and a second resultant value, the second resultant value being obtained by

(1) subtracting the absolute value of the coordinate transformation term, and the sectional minimum value, from the sectional maximum value to obtain a first resultant value, and

(2) multiplying the first resultant value by a constant to obtain the second resultant value.

10. A maximum likelihood sequence estimator as set forth in claim 9, wherein:

said sampling means (10) is arranged to sample the reception signals at the symbol interval T with respect to the respective sampling phases of the sampling phase sequences $\tau = \{\tau (i)\}$ (i = 1, 2, ..., M), starting from an estimated leading time Et slot (k) determined by a frame synchronisation mechanism when processing the kth assigned time slot to obtain sample value sequences $y_l$ i = {yin} (i = 1, 2, ..., M; n = 1, 2, ..., Nt) of the reception signals,

said correlation value calculating means (102) is configured to obtain the complex cross-correlation functions Ci of the training sequences based on the sample value sequences $y$ i and the training sequences $\phi$ = {$\phi$n} (n = 1, 2, ..., Nt) of the sample value sequences yi, according to the following equation:

$$Ci = \sum_{j=1}^{Nt} yij(\Phi j^*)$$

(where, i = 1, 2, ..., M; * means that complex conjugation is used), and

said sampling phase smoothing means is arranged to obtain

(a) the coordinate transformation term as a coordinate transformation term tc(k), according to the equations given below:

$$\Delta tc(k) = Et\ slot\ (k) - Et\ slot\ (k-1) \qquad k > 1$$

$$tc(k) = \begin{cases} \sum_{i=1}^{k-1} \Delta tc(i) & k > 1 \\ \\ 0 & k = 1, \end{cases}$$

(b) the sectional weighted mean value, the sectional maximum value and the sectional minimum value respectively as a sectional weighted mean value $\tau$ avg (k), a sectional maximum value $\tau$ max (k) and a sectional minimum value $\tau$ min (k) of the sampling phase $\tau$sel(k), according to the following equations:

$$\tau max(k) = \begin{cases} \max_{1 \le j \le k} (\tau sel(j) + tc(j)) & k < Ls \\ \\ \max_{k - Ls + 1 \le j \le k} (\tau sel(j) + tc(j)) & k \ge Ls \end{cases}$$

$$\tau min(k) = \begin{cases} \min_{1 \le j \le k} (\tau sel(j) + tc(j)) & k < Ls \\ \\ \min_{k - Ls + 1 \le j \le k} (\tau sel(j) + tc(j)) & k \ge Ls \end{cases}$$

$$\tau avg(k) = \begin{cases} \dfrac{\sum_{j=1}^{k} \{wa(k - j + 1)(\tau sel(j) + tc(j))\}}{\sum_{j=1}^{k} wa(j)} & k < Ls \\ \\ \dfrac{\sum_{j=k-Ls+1}^{k} \{wa(k - j + 1)(\tau sel(j) + tc(j))\}}{\sum_{j=1}^{Ls} wa(j)} & k \ge Ls \end{cases}$$

(where, wa (j) (j = 1, 2, ..., Ls) is a weighted coefficient and Ls denotes the maximum calculation length),
and
(c) the selective sampling phase $\tau$s according to the following equation:

$$\tau s = \tau\ avg(k) - tc(k) + ws\ (\tau max(k) - \tau min(k) - |tc\ (k)|)$$

(where, ws indicates the shift coefficient, wa (j) (j = 1, 2, ..., Ls) is a weighted coefficient and Ls denotes the maximum calculation length).

**11.** A maximum likelihood sequence estimator as set forth in claim 8, wherein:

said sampling means (101) is arranged to sample the reception signals at the symbol interval T, starting from an estimated leading time determined by a frame synchronisation mechanism, and
said sampling phase smoothing means (301) is arranged to obtain first and second coordinate transformation terms in accordance with the estimated leading time, to add the second coordinate transformation term to the sampling phase $\tau sel(k)$, to obtain the sectional weighted mean value, sectional maximum value and sectional minimum value of the sampling phase $\tau sel(k)$ after adding the second coordinate transformation term to the sample phase $\tau sel(k)$, and to calculate the sampling phase $\tau sel$ by respectively subtracting the sectional minimum value and the absolute value of the first coordinate transformation term from the sectional maximum value to obtain a first resultant value, multiplying the first resultant value by a constant to obtain a second resultant value, and to add the second resultant value to the sectional weighted mean value.

**12.** A maximum likelihood sequence estimator as set fort in claim 11, wherein:

said sampling means (101) is arranged to sample the reception signals, at the symbol interval T with respect to the respective sampling phases of the sampling phase sequences $\tau = \{\tau\ (i)\}$ (i = 1, 2, ..., M), starting from the estimated leading time slot Et slot (k) determined by the frame synchronisation mechanism when processing the kth assigned time slot to obtain the sample value sequences $Y_i = \{yin\}$ (i = 1, 2, ..., M; n = 1, 2, ..., Nt) of the reception signals y(t),
said correlation value calculating means (102) is configured to obtain complex cross-correlation function Ci of the training sequences $\Phi$ based on the sample value sequences $y_i$ and the training sequences $\phi = \{\phi n\}$ (n = 1, 2, ..., Nt) of the sample value sequences $y_i$, according to the following equation:

$$Ci = \sum_{j=1}^{Nt} yij\ (\Phi j^{*})$$

(where, i = 1, 2, ..., M; * means that complex conjunction is used),
and
said sampling phase smoothing means (401) is configured to obtain

(a) the first and second coordinate transformation terms, respectively as a first coordinate transformation term tc1(k) and a second coordinate transformation term tc2(j, k), according to the following equations at the time of the kth sample phase selection:

$$\Delta tc(k) = \begin{cases} Et\ slot\ (k) - Et\ slot\ (k - 1) & k > 1 \\ 0 & k \leq 1 \\ 0 & k \leq 1 \end{cases}$$

$$tc1(k) = \begin{cases} \sum_{i=1}^{k-1} \Delta tc\ (i + 1) & k < Ls \\ \\ \sum_{i=k-Ls}^{k-1} \Delta tc\ (i + 1) & k \geq Ls \end{cases}$$

$$tc2(j,\ k) = \begin{cases} \sum_{i=j}^{k-1} \Delta tc\ (i + 1) & j < k \\ \\ 0 & j \geq k, \end{cases}$$

(b) the sectional weighted means value, the sectional maximum value and the selectional minimum value, respectively as a sectional weighted mean value $\tau$ AVG (k), a sectional maximum value $\tau$ MAX (k) and a sectional minimum value $\tau$ MIN (k) of the sampling phase $\tau$sel(k), according to the following equations:

$$\tau\,MAX(k) = \begin{cases} \max_{1 \leq j \leq k}\ (\tau sel(j) + tc2(j,\ k)) & k < Ls \\ \\ \max_{k - Ls + 1 \leq j \leq k}\ (\tau sel(j) + tc2(j,\ k)) & k \geq Ls \end{cases}$$

$$\tau\,MIN(k) = \begin{cases} \min_{1 \leq j \leq k}\ (\tau sel(j) + tc2(j,\ k)) & k < Ls \\ \\ \min_{k - Ls + 1 \leq j \leq k}\ (\tau sel(j) + tc2(j,\ k)) & k \geq Ls \end{cases}$$

(where, wa (j) (j = 1, 2, ..., Ls) is a weighted coefficient and Ls denotes the maximum calculation length),
and
(c) the selecting sampling phase $\tau$s according to the following equation:

$$\tau s = \tau\ AVG\ (k) + ws\ (\tau\ MAX\ (k) - \tau\ MIN\ (k) - |tc1\ (k)|)$$

(where, ws indicates the shift coefficient, wa (j) (j = 1,2, ..., Ls) is a weighted coefficient and Ls denotes the maximum calculation length).

**13.** A maximum likelihood sequence estimator as set forth in claim 10, 11 or 12 further comprising a delay processing part (110) for delaying the reception signals and outputting the signals to said sampling processing part, wherein:

the sampling phase sequences $\tau = \{\tau (i)\}$ (i = 1, 2, ..., M) in said sampling means are simple non-increasing or simple non-decreasing,

said sampling processing part (120) is operable to sample the reception signals from said delay processing part,

said transmission estimating part (140) is arranged to obtain first estimated values E|h = {Ehj} (j = 0, 1, ..., L) of the impulse responses of the transmission path from the sample value sequences $\mathcal{Y}$ , according to an adaptive equalisation algorithm,

said transmission estimating part (140) is arranged to obtain estimated values Eh from the sample value sequences $\mathcal{Y}$ and estimated values Ex = {Exn} (n = 1, 2, ..., N) of transmission symbol sequences according to the adaptive equalisation algorithm, and

said operation processing part (130) is operable to the estimated values Ex according to a Viterbi algorithm.

14. A maximum likelihood sequence estimating method comprising:

sampling reception signals y(t) from a transmission path, at a symbol interval T with respect to respective sampling phases of sampling phase sequences τ = {T (i)} (i = 1, 2, ..., M), to obtain sample value sequences $\mathcal{Y}$i = {yin} (i - 1, 2, ..., M; n = 1, 2, ..., Nt) of the reception signals y(t)

obtaining complex cross-correlation functions $\mathcal{C}$ = {Ci} (i = 1, 2, ..., M) of the sample value sequences $\mathcal{Y}$i and training sequences $\phi$ = {φn} (n = 1, 2, ..., Nt) of the sample value sequences $\mathcal{Y}$i, and

selecting a sampling phase at which the absolute values of the number M of complex cross-correlation functions Ci are maximised by comparing the absolute values,

obtaining estimated values E|h = {Ehj} (j = 0, 1, ... L), of impulse responses of the transmission path according to an adaptive equalising algorithm with respect to the sample value sequences $\mathcal{Y}$ and the corresponding training sequence $\phi$ thereto and from estimated values Ex of the transmission symbol sequences and the sample value sequences $\mathcal{Y}$ , and

using the Viterbi algorithm to obtain the estimated values Ex = {Exn} (n = 1, 2, ..., N) of transmission symbol sequences from the sample value sequences $\mathcal{Y}$ based on the estimated values E|h, **characterised by** obtaining a sampling phase τs based on the selected sampling phase such that the bit error rate is minimised, sampling the reception signals y(t) entered at specified timings with respect to a symbol interval T and the sampling phase τs to obtain sample value sequences $\mathcal{Y}$ = {yn} (n = 1, 2, ..., N).

15. A method as set forth in claim 14, including obtaining an index Ik from the selected sampling phase designated τ(Ik), obtaining a weighted means value, a maximum value and a minimum value of the index Ik, obtaining an index Is by subtracting the minimum value from the maximum value to obtain a first resultant value, multiplying the first resultant value by a constant to obtain a second resultant value, and adding the second resultant value to the weighted mean value, so as to obtain the sampling phase τs corresponding to the index Is.

16. A method as set forth in claim 15, including obtaining a weighted mean value, a maximum value and a minimum value of the index Ik every predetermined section.

17. A method as set forth in claim 14, including sampling the reception signals y(t) at a symbol interval T with respect to respective sampling phases of simple non-increasing or simple non-decreasing sampling phase sequences τ = {τ(i)} (i = 1, 2, ..., M) to obtain the sample value sequences $\mathcal{Y}$ i, and obtaining the complex cross-correlation functions Ci of the training sequences $\phi$, according to the following equation

$$Ci = \sum_{j=1}^{Nt} yij(\Phi j^*)$$

(where, i = 1, 2, ..., M: * means that complex conjunction is used).

18. A method according to claim 17 including obtaining:

(1) the weighted means value, maximum value and minimum value of the index Ik for every predetermined section respectively as a sectional weighted mean value I avg (k), a sectional maximum value I max (k) and a sectional minimum value I min (k) of the index Ik, calculated according to the following equations at the time of the kth sampling phase selection:

$$
\text{Imax}(k) = \begin{cases} \max\limits_{1 \le j \le k} I_j & k < L_s \\[2ex] \max\limits_{k - L_s + 1 \le j \le k} I_j & k \ge L_s \end{cases}
$$

$$
\text{Imin}(k) = \begin{cases} \min\limits_{1 \le j \le k} I_j & k < L_s \\[2ex] \min\limits_{k - L_s + 1 \le j \le k} I_j & k \ge L_s \end{cases}
$$

$$
\text{Iavg}(k) = \begin{cases} \dfrac{\sum\limits_{j=1}^{k} \{w_a (k - j + 1)\, I_j\}}{\sum\limits_{j=1}^{k} w_a (j)} & k < L_s \\[4ex] \dfrac{\sum\limits_{j=k-L_s+1}^{k} \{w_a (k - j + 1)\, I_j\}}{\sum\limits_{j=1}^{L_s} w_a (j)} & k \ge L_s \end{cases}
$$

(where, $w_a(j)$ ($j = 1, 2, ..., L_s$) is a weighted coefficient and $L_s$ denotes the maximum length of calculation), (2) a selective sampling phase index $I_s$ according to the following equation:

$$
I_s = [I_{avg}(k) + w_s (I_{max}(k) - I_{min}(k))]
$$

(where, [ ] indicates the Gaussian notation which returns the largest integer not exceeding a value in the notation and $w_s$ denotes a shift coefficient), and
(3) the sampling phase $\tau_s$ corresponding to the index $I_s$ according to the following equation:

$$
\tau_s = \begin{cases} \tau(1) & I_s < 1 \\ \tau(I_s) & 1 \le I_s \le M \\ \tau(M) & M < I_s. \end{cases}
$$

**19.** A method as set forth in claim 16 including obtaining:

(1) the weighted mean value, maximum value and minimum value of the index Ik for every predetermined section respectively as a weighted means value I AVG (k), a maximum value I MAX (k) and a minimum value I MIN (k) of the index Ik, calculated according to the following equations at the time of the kth sampling phase selection:

$$I \ MAX(k) \ = \quad \max_{1 \le j \le k} \ Ij$$

$$I \ MIN(k) \ = \quad \min_{1 \le j \le k} \ Ij$$

$$I \ AVG(k) = (1 - \alpha) \ I \ AVG \ (k - 1) + \alpha Ik \ (\alpha: \ constant)$$

$$I \ AVG(O) = 0$$

(2) a selective sampling phase index Is according to the following equation:

$$Is = [I \ AVG \ (k) + ws \ (I \ MAX \ (k) - I \ MIN \ (k))]$$

(where, [ ] indicates the Gaussian notation which returns the largest integer not exceeding a value in the notation and ws denotes a shift coefficient),
and
(3) the sampling phase $\tau$s corresponding to the index Is according to the following equation:

$$\tau s = \begin{cases} \tau \ (1) & Is < 1 \\ \tau \ (Is) & 1 \le Is \le M \\ \tau \ (M) & M < Is. \end{cases}$$

**20.** A method as set forth in claim 19, including obtaining a sectional weighted mean value, a sectional maximum value and a sectional minimum value, all of a sampling phase $\tau$sel(k) obtained as the selected sampling phase by said selecting means, and to obtain the sampling phase $\tau$s based on the sectional weighted mean value, the sectional maximum value and the sectional minimum value.

**21.** A method as set forth in claim 20, including:

sampling the reception signals at the symbol interval T, starting from an estimated leading time determined by a frame synchronisation mechanism, obtaining a coordinate transformation term in accordance with the estimated leading time, adding the coordinate transformation term to the sampling phase $\tau$sel(k), obtaining the sectional weighted mean value, a sectional maximum value and a sectional minimum value of the sampling phase $\tau$sel(k) after adding the coordinate transformation term to the sampling phase $\tau$sel(k), and to calculating the sampling phase $\tau$s by respectively subtracting from and adding to the sectional weighted mean value, the coordinate transformation term and a second resultant value, the second resultant value being obtained by

(1) subtracting the absolute value of the coordinate transformation term, and the sectional minimum value,

from the sectional maximum value to obtain a first resultant value, and
(2) multiplying the first resultant value by a constant to obtain the second resultant value.

**22.** A method as set forth in claim 21, wherein:

sampling the reception signals at the symbol interval T with respect to the respective sampling phases of the sampling phase sequences $\tau = \{\tau (i)\}$ (i = 1, 2, ..., M), starting from an estimated leading time Et slot (k) determined by a frame synchronisation mechanism when processing the kth assigned time slot to obtain sample value sequences $y_i$ i = {yin} (i = 1, 2, ..., M; n = 1, 2, ..., Nt) of the reception signals,
obtaining the complex cross-correlation functions Ci of the training sequences $\phi$ based on the sample value sequences yi and the training sequences $\phi = \{\phi n\}$ (n = 1, 2, ..., Nt) of the sample value sequences $y_i$ i, according to the following equation:

$$Ci = \sum_{j=1}^{Nt} yij(\Phi j^*)$$

(where, i = 1, 2, ..., M; * means that complex conjugation is used),
and
obtaining

(a) the coordinate transformation term as a coordinate transformation term tc(k), according to the equations given below:

$$\Delta tc(k) = Et\ slot\ (k) - Et\ slot\ (k-1) \qquad k > 1$$

$$tc(k) = \begin{cases} \sum_{i=1}^{k-1} \Delta tc\ (i) & k > 1 \\ \\ 0 & k = 1, \end{cases}$$

(b) the sectional weighted mean value, the sectional maximum value and the sectional minimum value respectively as a sectional weighted mean value $\tau$ avg (k), a sectional maximum value $\tau$ max (k) and a sectional minimum value $\tau$ min (k) of the sampling phase $\tau$sel(k), according to the following equations:

$$\tau max(k) = \begin{cases} \max_{1 \le j \le k} (\tau sel(j) + tc\ (j)) & k < Ls \\ \\ \max_{k - Ls + 1 \le j \le k} (\tau sel(j) + tc\ (j)) & k \ge Ls \end{cases}$$

$$\tau \min(k) = \begin{cases} \min_{1 \le j \le k} (\tau sel(j) + tc(j)) & k < Ls \\ \\ \min_{k-Ls+1 \le j \le k} (\tau sel(j) + tc(j)) & k \ge Ls \end{cases}$$

$$\tau avg(k) = \begin{cases} \dfrac{\sum\limits_{j=1}^{k} \{wa(k-j+1)(\tau sel(j) + tc(j))\}}{\sum\limits_{j=1}^{k} wa(j)} & k < Ls \\ \\ \dfrac{\sum\limits_{j=k-Ls+1}^{k} \{wa(k-j+1)(\tau sel(j) + tc(j))\}}{\sum\limits_{j=1}^{Ls} wa(j)} & k \ge Ls \end{cases}$$

(where, wa (j) (j = 1, 2, ..., Ls) is a weighted coefficient and Ls denotes the maximum calculation length),
and
(c) the selective sampling phase τs according to the following equation:

$$\tau s = \tau avg(k) - tc(k) + ws(\tau max(k) - \tau min(k) - |tc(k)|)$$

(where, ws indicates the shift coefficient, wa (j) (j = 1, 2, ..., Ls) is a weighted coefficient and Ls denotes the maximum calculation length).

**23.** A method as set forth in claim 20, including:

sampling the reception signals at the symbol interval T, starting from an estimated leading time determined by a frame synchronisation mechanism, and
obtaining first and second coordinate transformation terms in accordance with the estimated leading time, adding the second coordinate transformation term to the sampling phase τsel(k), obtaining the sectional weighted mean value, sectional maximum value and sectional minimum value of the sampling phase τsel(k) after adding the second coordinate transformation term to the sample phase τsel(k), and calculating the sampling phase τsel by respectively subtracting the sectional minimum value and the absolute value of the first coordinate transformation term from the sectional maximum value to obtain a first resultant value, multiplying the first resultant value by a constant to obtain a second resultant value, and to add the second resultant value to the sectional weighted mean value.

**24.** A maximum likelihood sequence estimator as set forth in claim 22, including:

sampling the reception signals entered from the transmission lines, at the symbol interval T with respect to the respective sampling phases of the sampling phase sequences $\tau = \{\tau(i)\}$ (i = 1, 2, ..., M), starting from the

27

estimated leading time slot Et slot (k) determined by the frame synchronisation mechanism when processing the kth assigned time slot to obtain the sample value sequences yi = {yin} (i = 1, 2, ..., M; n = 1, 2, ..., Nt) of the reception signals y(t),

obtaining complex cross-correlation function Ci of the training sequences $\phi$ based on the sample value sequences yi and the training sequences $\phi$ = {$\phi$n} (n = 1, 2, ..., Nt) of the sample value sequences y/ i, according to the following equation:

$$Ci = \sum_{j=1}^{Nt} yij(\Phi j^*)$$

(where, i = 1, 2, ..., M; * means that complex conjunction is used),
and
obtaining

(a) the first and second coordinate transformation terms, respectively as a first coordinate transformation term tc1(k) and a second coordinate transformation term tc2(j, k), according to the following equations at the time of the kth sample phase selection:

$$\Delta tc(k) = \begin{cases} Et\ slot\ (k)\ -\ Et\ slot\ (k-1) & k > 1 \\ 0 & k \le 1 \\ 0 & k \le 1 \end{cases}$$

$$tc1(k) = \begin{cases} \sum_{i=1}^{k-1} \Delta tc\ (i+1) & k < Ls \\ \sum_{i=k-Ls}^{k-1} \Delta tc\ (i+1) & k \ge Ls \end{cases}$$

$$tc2(j,\ k) = \begin{cases} \sum_{i=j}^{k-1} \Delta tc\ (i+1) & j < k \\ 0 & j \ge k, \end{cases}$$

(b) the sectional weighted means value, the sectional maximum value and the selectional minimum value, respectively as a sectional weighted mean value $\tau$ AVG (k), a sectional maximum value $\tau$ MAX (k) and a sectional minimum value $\tau$ MIN (k) of the sampling phase $\tau$sel(k), according to the following equations:

$$\tau\,MAX(k) = \begin{cases} \max_{1 \le j \le k} (\tau sel(j) + tc2(j,\ k)) & k < Ls \\[2em] \max_{k - Ls + 1 \le j \le k} (\tau sel(j) + tc2(j,\ k)) & k \ge Ls \end{cases}$$

$$\tau\,MIN(k) = \begin{cases} \min_{1 \le j \le k} (\tau sel(j) + tc2(j,\ k)) & k < Ls \\[2em] \min_{k - Ls + 1 \le j \le k} (\tau sel(j) + tc2(j,\ k)) & k \ge Ls \end{cases}$$

$$\tau\,AVG(k) = \begin{cases} \dfrac{\sum\limits_{j=1}^{k} \{wa\,(k - j + 1)\,(\tau sel(j) + tc2(j,\ k))\}}{\sum\limits_{j=1}^{k} wa\,(j)} & k < Ls \\[3em] \dfrac{\sum\limits_{j=k-Ls+1}^{k} \{wa\,(k - j + 1)\,(\tau sel(j) + tc2(j,\ k))\}}{\sum\limits_{j=1}^{Ls} wa\,(j)} & k \ge Ls \end{cases}$$

(where, wa (j) (j = 1, 2, ..., Ls) is a weighted coefficient and Ls denotes the maximum calculation length),
and
(c) the selecting sampling phase $\tau s$ according to the following equation:

$$\tau s = \tau\,AVG\,(k) + ws\,(\tau\,MAX\,(k) - \tau\,MIN\,(k) - |tc1\,(k)|)$$

(where, ws indicates the shift coefficient, wa (j) (j = 1,2, ..., Ls) is a weighted coefficient and Ls denotes the maximum calculation length).

25. A method as set forth in claim 18, 19, 21 or 23 including:

delaying the reception signals,

sampling the delayed reception signals,
obtaining first estimated values E|h = {Ehj} (j = 0, 1, ..., L) of the impulse responses of the transmission path from the sample value sequences $y$ and training sequences $\phi$ corresponding to the sample value sequences $y$, according to an adaptive equalisation algorithm,
obtaining estimated values Eh from the sample value sequences $y$ and estimated values $Ex$ = {Exn} (n = 1, 2, ..., N) of transmission symbol sequences according to the adaptive equalisation algorithm, and
obtaining the estimated values $Ex$ according to a Viterbi algorithm.

**Patentansprüche**

1. Einrichtung zum Schätzen von Maximalwahrscheinlichkeitsfolgen, die umfaßt:

   eine Abtasteinrichtung (101-1, 101-M) zum Abtasten von Empfangssignalen y(t) von einem Übertragungspfad in einem Symbolintervall T in bezug auf jeweilige Abtastphasen von Abtastphasenfolgen τ = {τ(i)} (i = 1, 2,... M), um Abtastwertfolgen y|i = {yin} (i = 1, 2, ... M; n = 1, 2, ... Nt) der Empfangssignale y(t) zu erhalten,
   eine Korrelationswert-Berechnungseinrichtung (102-1, 102M) zum Erhalten komplexer Kreuzkorrelationsfunktionen C|= {Ci} (i = 1, 2, ..., M) der Abtastwertfolgen y|i und von Trainingsfolgen φ| = {φn} (n = 1, 2, ..., Nt) der Abtastwertfolgen y|i, und
   eine Auswahleinrichtung (103, 302) zum Erhalten einer ausgewählten Abtastphase, bei der die Absolutwerte der Anzahl M komplexer Kreuzkorrelationsfunktionen Ci maximal sind, indem die Absolutwerte verglichen werden;
   einen Übertragungspfad-Schätzabschnitt (140) zum Erhalten geschätzter Werte E|h = {Ehj} (j = 0, 1, ..., L) von Impulsantworten des Übertragungspfades entsprechend einem adaptiven Angleichungsalgorithmus in bezug auf die Abtastwertfolgen y| und die entsprechenden Trainingsfolgen φ| hierfür und aus geschätzten Werten Ex| der Übertragungssymbolfolgen und der Abtastwertfolgen y|; und
   einen Viterbi-Algorithmus-Verarbeitungsabschnitt (130) zum Erhalten der geschätzten Werte Ex| = {Exn} (n = 1, 2, ..., N) von Übertragungssymbolfolgen aus den Abtastwertfolgen y| anhand der geschätzten Werte E|h, **gekennzeichnet durch**
   eine Abtastphasen-Glättungseinrichtung (104, 201, 301, 401) zum Erhalten einer Abtastphase τs anhand der ausgewählten Abtastphase, die **durch** die Auswahleinrichtung erhalten wird, derart, daß die Bitfehlerrate minimal ist,
   einen Abtastverarbeitungsabschnitt (120) zum Abtasten der Empfangssignale y(t), die zu spezifizierten Zeitpunkten in bezug auf ein Symbolintervall T und die Abtastphase τs eingegeben werden, um Abtastwertfolgen y| = {yn} (n = 1, 2, ..., N) zu erhalten.

2. Einrichtung zum Schätzen von Maximalwahrscheinlichkeitsfolgen nach Anspruch 1, wobei :

   die Auswahleinrichtung (103) so konfiguriert ist, daß sie aus der mit τ(Ik) bezeichneten ausgewählten Abtastphase einen Index Ik erhält, und
   die Abtastphasen-Glättungseinrichtung (104) so beschaffen ist, daß sie einen gewichteten Mittelwert, einen Maximalwert und einen Minimalwert des Index Ik erhält und, indem sie den Minimalwert vom Maximalwert subtrahiert, um einen ersten Ergebniswert zu erhalten, den ersten Ergebniswert mit einer Konstanten multipliziert, um einen zweiten Ergebniswert zu erhalten, und den zweiten Ergebniswert zum gewichteten Mittelwert addiert, einen Index Is erhält, wobei die Abtastphase τS dem Index Is entspricht.

3. Einrichtung zum Schätzen von Maximalwahrscheinlichkeitsfolgen nach Anspruch 2, wobei die Abtastphasen-Glättungseinrichtung (104) so betreibbar ist, daß sie einen gewichteten Mittelwert, einen Maximalwert und einen Minimalwert des Index Ik in jedem vorgegebenen Abschnitt erhält.

4. Einrichtung zum Schätzen von Maximalwahrscheinlichkeitsfolgen nach Anspruch 2 oder 3, wobei:

   die Abtasteinrichtung (101) so konfiguriert ist, daß sie die Empfangssignale y(t) in einem Symbolintervall T in bezug auf entsprechende Abtastphasen einfacher nicht zunehmender oder einfacher nicht abnehmender Abtastphasenfolgen τ{τ(i)} (i = 1, 2, ... , M) abtastet, um die Abtastwertfolgen y|i zu erhalten, und
   die Korrelationswert-Berechnungseinrichtung (102) so betreibbar ist, daß sie die komplexen Kreuzkorrelationsfunktionen Ci der Trainingsfolgen φ| gemäß der folgenden Gleichung erhält:

$$Ci = \sum_{j=1}^{Nt} yij\left(\Phi j^{*}\right)$$

(wobei i = 1, 2, ..., M: * bedeutet, daß die Komplexkonjugation verwendet wird)

5. Einrichtung zum Schätzen von Maximalwahrscheinlichkeitsfolgen nach Anspruch 4, wobei:

die Abtastphasen-Glättungseinrichtung (104) so beschaffen ist, daß sie erhält:

(1) den gewichteten Mittelwert, den Maximalwert und den Minimalwert des Index Ik für jeden vorgegebenen Abschnitt als einen gewichteten Abschnittsmittelwert I avg (k), einen Abschnittsmaximalwert I max (k) und einen Abschnittsminimalwert I min (k) des Index Ik, die gemäß den folgenden Gleichungen zum Zeitpunkt der Auswahl der k-ten Abtastphase berechnet werden:

$$I\ max\ (k)\ =\ \begin{cases} \max_{1\leq j\leq k} Ij & k < Ls \\ \max_{k-Ls+1\leq j\leq k} Ij & k \geq Ls \end{cases}$$

$$I\ min\ (k)\ =\ \begin{cases} \min_{1\leq j\leq k} Ij & k < Ls \\ \min_{k-Ls+1\leq j\leq k} Ij & k \geq Ls \end{cases}$$

$$I\ avg\ (k)\ =\ \begin{cases} \dfrac{\displaystyle\sum_{j=1}^{k} \left(wa(k - j + 1)Ij\right)}{\displaystyle\sum_{j=1}^{k} wa(j)} & k < Ls \\[20pt] \dfrac{\displaystyle\sum_{j=k-Ls+1}^{k} \left(wa(k - j + 1)Ij\right)}{\displaystyle\sum_{j=1}^{Ls} wa(j)} & k > Ls \end{cases}$$

(wobei wa(j) (j = 1, 2, ..., Ls) ein gewichteter Koeffizient ist und Ls die maximale Länge der Berechnung bezeichnet),
(2) einen selektiven Abtastphasenindex Is gemäß der folgenden Gleichung:

Is = [I avg (k) + ws (I max (k) - I min (k))]

(wobei [ ] die Gaußsche Notation angibt, die die größte ganze Zahl, die einen Wert in der Notation nicht übersteigt, bezeichnet, und ws einen Verschiebungskoeffizienten bezeichnet),

und

(3) die Abtastphase τs, die dem Index Is entspricht, gemäß der folgenden Gleichung:

$$\tau = \begin{bmatrix} \tau(1) & \text{Is} < 1 \\ \tau(\text{Is}) & 1 \leq \text{Is} \leq M \\ \tau(M) & M < \text{Is} \end{bmatrix}.$$

**6.** Einrichtung zum Schätzen von Maximalwahrscheinlichkeitsfolgen nach Anspruch 4, wobei:

die Abtastphasen-Glättungseinrichtung (104) so beschaffen ist, daß sie erhält:

(1) den gewichteten Mittelwert, den Maximalwert und den Minimalwert des Index Ik für jeden vorgegebenen Abschnitt als einen gewichteten Mittelwert I AVG (k), einen Maximalwert I MAX (k) und einen Minimalwert I MIN (k) des Index Ik, der gemäß den folgenden Gleichungen zum Zeitpunkt der Auswahl der k-ten Abtastphase berechnet wird:

$$I\ MAX\ (k) = \max_{1 \leq j \leq k} Ij$$

$$I\ MIN\ (k) = \min_{1 \leq j \leq k} Ij$$

$$I\ AVG\ (k) = (1 - \alpha)\ I\ AVG\ (k - 1) + \alpha Ik$$

$$(\alpha\text{: Konstante})$$

$$I\ AVG\ (0) = 0$$

(2) einen selektiven Abtastphasenindex Is gemäß der folgenden Gleichung:

$$Is = [I\ AVG\ (k) + ws(I\ MAX\ (k) - I\ MIN\ (k))]$$

(wobei [ ] die Gaußsche Notation angibt, die die größte ganze Zahl, die einen Wert in der Notation nicht übersteigt, bezeichnet, und ws einen Verschiebungskoeffizienten bezeichnet), und

(3) die Abtastphase τs, die dem Index Is entspricht, gemäß der folgenden Gleichung:

$$\tau = \begin{bmatrix} \tau(1) & \text{Is} < 1 \\ \tau(\text{Is}) & 1 \leq \text{Is} \leq M \\ \tau(M) & M < \text{Is} \end{bmatrix}.$$

**7.** Einrichtung zum Schätzen von Maximalwahrscheinlichkeitsfolgen nach Anspruch 5 oder 6, die ferner einen Verzögerungsverarbeitungsabschnitt (110) umfaßt zum Verzögern der von den Übertragungsleitungen eingegebenen Empfangssignale so lange wie spezifiziert und zum Ausgeben der Signale an den Abtastverarbeitungsabschnitt, wobei:

der Abtastverarbeitungsabschnitt (120) so betreibbar ist, daß er die Empfangssignale vom Verzögerungsverarbeitungsabschnitt abtastet,

der Übertragungsschätzabschnitt (140) so beschaffen ist, daß er erste geschätzte Werte E|h = {Ehj} (j = 1, ..., L) für die Impulsantworten der Übertragungsleitungen von den Abtastwertfolgen y| und den den Abtastwertfolgen y| entsprechenden Trainingsfolgen φ| gemäß einem adaptiven Angleichungsalgorithmus erhält,

der Übertragungsschätzabschnitt (140) so beschaffen ist, daß er zweite geschätzte Werte E|h aus den Abtastwertfolgen y| und den geschätzten Werten E|x = {Exn} (n = 1, 2, ..., N) der Übertragungssymbolfolgen gemäß dem adaptiven Angleichungsalgorithmus erhält, und

der Operationsverarbeitungsabschnitt (130) so betreibbar ist, daß er die geschätzten Werte E|x gemäß einem Viterbi-Algorithmus erhält.

8. Einrichtung zum Schätzen von Maximalwahrscheinlichkeitsfolgen nach Anspruch 1, wobei die Abtastphasen-Glättungseinrichtung (301) so beschaffen ist, daß sie einen gewichteten Abschnittsmittelwert, einen Abschnittsmaximalwert und einen Abschnittsminimalwert sämtlich aus einer Abtastphase $\tau$sel(k) erhält, die ihrerseits von der Auswahleinrichtung als die ausgewählte Abtastphase erhalten wird, und daß sie die Abtastphase $\tau$s anhand des gewichteten Abschnittsmittelwerts, des Abschnittsmaximalwerts und des Abschnittsminimalwerts erhält.

9. Einrichtung zum Schätzen von Maximalwahrscheinlichkeitsfolgen nach Anspruch 8, wobei:

die Abtasteinrichtung (101) so beschaffen ist, daß sie die Empfangssignale in dem Symbolintervall T abtastet und dabei bei einem geschätzten Anfangszeitpunkt, der durch einen Rahmensynchronisationsmechanismus bestimmt ist, beginnt,

die Abtastphasen-Glättungseinrichtung so beschaffen ist, daß sie einen Koordinatentransformationsterm gemäß dem geschätzten Anfangszeitpunkt erhält, den Koordinatentransformationsterm zu der Abtastphase $\tau$sel (k) addiert, den gewichteten Abstandsmittelwert, einen Abschnittsmaximalwert und einen Abschnittsminimalwert der Abtastphase $\tau$sel(k) erhält, nachdem sie den Koordinatentransformationsterm zur Abtastphase $\tau$sel (k) addiert hat, und die Abtastphase $\tau$s durch Subtrahieren des Koordinatentransformationsterms vom gewichteten Abstandsmittelwert bzw. durch Addieren eines zweiten Ergebniswerts zum gewichteten Abschnittsmittelwert berechnet, wobei der zweite Ergebniswert erhalten wird durch:

(1) Subtrahieren des Absolutwerts des Koordinatentransformationsterms und des Abschnittsmittelwerts vom Abschnittsmaximalwert, um einen ersten Ergebniswert zu erhalten, und
(2) Multiplizieren des ersten Ergebniswerts mit einer Konstanten, um den zweiten Ergebniswert zu erhalten.

10. Einrichtung zum Schätzen von Maximalwahrscheinlichkeitsfolgen nach Anspruch 9, wobei:

die Abtasteinrichtung (10) so beschaffen ist, daß sie die Empfangssignale in dem Symbolintervall T in bezug auf die jeweiligen Abtastphasen der Abtastphasenfolgen $\tau = \{\tau(i)\}$ (i = 1, 2, ..., M) beginnend bei einem geschätzten Anfangszeitpunkt Et slot (k), der durch einen Rahmensynchronisationsmechanismus bestimmt ist, abtastet, wenn der k-te zugewiesene Zeitschlitz verarbeitet wird, um Abtastwertfolgen y|i = {yin} (i = 1, 2, ..., M; n = 1, 2, ..., Nt) der Empfangssignale zu erhalten,

die Korrelationswert-Berechnungseinrichtung (102) so konfiguriert ist, daß sie die komplexen Kreuzkorrelationsfunktionen Ci der Trainingsfolgen anhand der Abtastwertfolgen y|i und der Trainingsfolgen φ| = {φn} (n = 1, 2, ..., Nt) der Abtastwertfolgen yi gemäß der folgenden Gleichung erhält:

$$Ci = \sum_{j=1}^{Nt} yij\left(\Phi j^{*}\right)$$

(wobei i = 1, 2, ..., M; * bedeutet, daß die Komplexkonjugation verwendet wird),
und
die Abtastphasen-Glättungseinrichtung so beschaffen ist, daß sie erhält:

(a) den Koordinatentransformationsterm als einen Koordinatentransformationsterm tc(k) gemäß der im

folgenden angegebenen Gleichungen:

$$\Delta tc(k) = Et\ slot\ (k) - Et\ slot\ (k-1) \qquad k > 1$$

$$tc(k) \;=\; \left[ \begin{array}{ll} \displaystyle\sum_{i=1}^{k-1} \Delta tc(i) & k > 1 \\[2ex] 0 & k = 1 \end{array} \right.$$

(b) den gewichteten Abstandsmittelwert, den Abschnittsmaximalwert und den Abschnittsminimalwert als einen gewichteten Abstandsmittelwert $\tau\ avg\ (k)$ bzw. einen Abschnittsmaximalwert $\tau\ max\ (k)$ bzw. einen Abschnittsminimalwert $\tau\ min\ (k)$ der Abtastphase $\tau sel(k)$ gemäß den folgenden Gleichungen:

$$\tau\ max\ (k) \;=\; \left[ \begin{array}{ll} \displaystyle\max_{1\le j\le k} (\tau sel(j) + tc(j)) & k < Ls \\[2ex] \displaystyle\max_{k-Ls+1\le j\le k} (\tau sel(j) + tc(j)) & k \ge Ls \end{array} \right.$$

$$\tau\ min\ (k) \;=\; \left[ \begin{array}{ll} \displaystyle\min_{1\le j\le k} (\tau sel(j) + tc(j)) & k < Ls \\[2ex] \displaystyle\min_{k-Ls+1\le j\le k} (\tau sel(j) + tc(j)) & k \ge Ls \end{array} \right.$$

$$\tau\ avg\ (k) \;=\; \left[ \begin{array}{ll} \dfrac{\displaystyle\sum_{j=1}^{k} (wa(k - j + 1)(\tau sel(j) + tc(j)))}{\displaystyle\sum_{j=1}^{k} wa(j)} & k < Ls \\[4ex] \dfrac{\displaystyle\sum_{j=k-Ls+1}^{k} (wa(k - j + 1)(\tau sel(j) + tc(j)))}{\displaystyle\sum_{j=1}^{Ls} wa(j)} & k \ge Ls \end{array} \right.$$

(wobei $wa(j)$ ($j = 1, 2, ..., Ls$) ein gewichteter Koeffizient ist und $Ls$ die maximale Berechnungslänge bezeichnet),
und
(c) die selektive Abtastphase $\tau s$ gemäß der folgenden Gleichung:

$$\tau s = \tau\ avg\ (k) - tc(k) + ws\ (\tau max(k) - \tau min(k) - |tc(k)|)$$

(wobei $ws$ den Verschiebungskoeffizienten angibt, $wa(j)$ ($j = 1, 2, ..., Ls$) ein gewichteter Koeffizient ist und $Ls$ die maximale Berechnungslänge bezeichnet).

**11.** Einrichtung zum Schätzen von Maximalwahrscheinlichkeitsfolgen nach Anspruch 8, wobei:

die Abtasteinrichtung (101) so beschaffen ist, daß sie die Empfangssignale in dem Symbolintervall T abtastet, wobei sie bei einem geschätzten Anfangszeitpunkt beginnt, der durch einen Rahmensynchronisationsmechanismus bestimmt wird, und
die Abtastphasen-Glättungseinrichtung (301) so beschaffen ist, daß sie erste und zweite Koordinatentransformationsterme gemäß dem geschätzten Anfangszeitpunkt erhält, den zweiten Koordinatentransformationsterm zur Abtastphase $\tau$sel(k) addiert, den gewichteten Abschnittsmittelwert, den Abschnittsmaximalwert und den Abschnittsminimalwert der Abtastphase $\tau$sel(k) nach der Addition des zweiten Koordinatentransformationsterms zur Abtastphase $\tau$sel(k) erhält und die Abtastphase $\tau$sel durch Subtrahieren des Abschnittsminimalwerts bzw. des Absolutwerts des ersten Koordinatentransformationsterms vom Abschnittsmaximalwert, um einen ersten Ergebniswert zu erhalten, durch Multiplizieren des ersten Ergebniswerts mit einer Konstanten, um einen zweiten Ergebniswert zu erhalten, und durch Addieren des zweiten Ergebniswerts zum gewichteten Abschnittsmittelwert berechnet.

**12.** Einrichtung zum Schätzen von Maximalwahrscheinlichkeitsfolgen nach Anspruch 11, wobei:

die Abtasteinrichtung (101) so beschaffen ist, daß sie die Empfangssignale in dem Symbolintervall T in bezug auf die jeweiligen Abtastphasen der Abtastphasenfolgen $\tau = \{\tau(i)\}$ (i = 1, 2, ..., M) abtastet, wobei sie bei dem geschätzten Anfangszeitschlitz Et slot (k) beginnt, der durch den Rahmensynchronisationsmechanismus bestimmt wird, wenn der k-te zugewiesene Zeitschlitz verarbeitet wird, um die Abtastwertfolgen y|i = {yin} (i = 1, 2, ..., M; n = 1, 2, ..., Nt) der Empfangssignale yt zu erhalten,
die Korrelationswert-Berechnungseinrichtung (102) so konfiguriert ist, daß sie die komplexe Kreuzkorrelationsfunktion Ci der Trainingsfolgen $\phi$| anhand der Abtastwertfolgen y|i und der Trainingsfolgen $\phi$| = {$\phi$n} (n = 1, 2, ..., Nt) der Abtastwertfolgen y|i gemäß der folgenden Gleichung erhält:

$$C_i = \sum_{j=1}^{Nt} y_{ij}\left(\Phi_j^*\right)$$

(wobei i = 1, 2, ..., M; * bedeutet, daß die Komplexkonjugation verwendet wird), und
die Abtastphasen-Glättungseinrichtung (401) so konfiguriert ist, daß sie erhält:

(a) die ersten und zweiten Koordinatentransformationsterme als einen ersten Koordinatentransformationsterm tc1(k) bzw. einen zweiten Koordinatentransformationsterm tc2(j,k) zum Zeitpunkt der Auswahl der k-ten Abtastphase gemäß den folgenden Gleichungen:

$$\Delta tc(k) = \begin{bmatrix} Et\,slot\,(k) - Et\,slot\,(k-1) & k > 1 \\ 0 & k \leq 1 \\ 0 & k \leq 1 \end{bmatrix}$$

$$tc1(k) = \begin{bmatrix} \sum_{i=1}^{k-1} \Delta tc(i+1) & k < Ls \\ \sum_{i=k-Ls}^{k-1} \Delta tc(i+1) & k \geq Ls \end{bmatrix}$$

$$tc2(j,k) = \begin{cases} \sum_{i=j}^{k-1} \Delta tc(i+1) & j < k \\ 0 & j \geq k \end{cases}$$

(b) die gewichteten Abschnittsmittelwerte, den Abschnittsmaximalwert und den Abschnittsminimalwert als einen gewichteten Abschnittsmittelwert $\tau$ AVG (k) bzw. einen Abschnittsmaximalwert $\tau$ MAX (k) bzw. einen Abschnittsminimalwert $\tau$ MIN (k) der Abtastphase $\tau$sel(k) gemäß den folgenden Gleichungen:

$$\tau\ MAX\ (k) = \begin{cases} \max_{1 \leq j \leq k} (\tau sel(j) + tc2(j,k)) & k < Ls \\ \max_{k-Ls+1 \leq j \leq k} (\tau sel(j) + tc2(j,k)) & k \geq Ls \end{cases}$$

$$\tau\ MIN\ (k) = \begin{cases} \min_{1 \leq j \leq k} (\tau sel(j) + tc2(j,k)) & k < Ls \\ \min_{k-Ls+1 \leq j \leq k} (\tau sel(j) + tc2(j,k)) & k \geq Ls \end{cases}$$

(wobei wa(j) (j = 1, 2, ..., Ls) ein Gewichtungskoeffizient ist und Ls die maximale Berechnungslänge bezeichnet),
und
(c) die ausgewählte Abtastphase $\tau$s gemäß der folgenden Gleichung:

$$\tau s = \tau\ AVG\ (k) + ws\ (\tau\ MAX\ (k) - \tau\ MIN\ (k) - |tc1\ (k)|)$$

(wobei ws den Verschiebungskoeffizienten angibt, wa(j) (j = 1, 2, ..., Ls) ein Gewichtungskoeffizient ist und Ls die maximale Berechnungslänge bezeichnet).

**13.** Einrichtung zum Schätzen von Maximalwahrscheinlichkeitsfolgen nach Anspruch 10, 11 oder 12, die ferner einen Verzögerungsverarbeitungsabschnitt (110) zum Verzögern der Empfangssignale und zum Ausgeben der Signale an den Abtastverarbeitungsabschnitt umfaßt, wobei:

die Abtastphasenfolgen $\tau = \{\tau(i)\}$ (i = 1, 2, ..., M) in der Abtasteinrichtung einfach nicht zunehmend oder einfach nicht abnehmend sind,
der Abtastverarbeitungsabschnitt (120) so betreibbar ist, daß er die Empfangssignale vom Verzögerungsverarbeitungsabschnitt abtastet,
der Übertragungsschätzabschnitt (140) so beschaffen ist, daß er erste geschätzte Werte E|h = {Ehj} (j = 0, 1, ..., L) der Impulsantworten des Übertragungspfades von den Abtastwertfolgen y| gemäß einem adaptiven Angleichungsalgorithmus erhält,
der Übertragungsschätzabschnitt (140) so beschaffen ist, daß er geschätzte Werte Eh von den Abtastwertfolgen y| und geschätzte Werte E|x = {Exn} (n = 1, 2, ..., N) von Übertragungssymbolfolgen gemäß dem adaptiven Angleichungsalgorithmus erhält, und
der Operationsverarbeitungsabschnitt (130) so betreibbar ist, daß er die geschätzten Werte E|x gemäß einem Viterbi-Algorithmus erhält.

**14.** Verfahren zum Schätzen von Maximalwahrscheinlichkeitsfolgen, das umfaßt:

Abtasten von Empfangssignalen y(t) von einem Übertragungspfad in einem Symbolintervall T in bezug auf die jeweiligen Abtastphasen von Abtastphasenfolgen $\tau = \{\tau(i)\}$ (i = 1, 2, ..., M, um Abtastwertfolgen y|i = {yin} (i = 1, 2, ..., M; n = 1, 2, ..., Nt) der Empfangssignale y(t) zu erhalten,
Erhalten komplexer Kreuzkorrelationsfunktionen C|= {Ci} (i = 1, 2, ..., M) der Abtastwertfolgen y|i und von

Trainingsfolgen $\phi| = \{\phi n\}$ (n = 1, 2, ..., Nt) der Abtastwertfolgen y|i, und

Auswählen einer Abtastphase, bei der die Absolutwerte der Anzahl M komplexer Kreuzkorrelationsfunktionen Ci maximal sind, indem die Absolutwerte verglichen werden;

Erhalten geschätzter Werte E|h = {Ehj} (j = 0, 1, ..., L) von Impulsantworten des Übertragungspfades entsprechend einem adaptiven Angleichungsalgorithmus in bezug auf die Abtastwertfolgen y| und die entsprechenden Trainingsfolgen $\phi|$ hierfür und aus geschätzten Werten Ex| der Übertragungssymbolfolgen und der Abtastwertfolgen y|; und

Verwenden des Viterbi-Algorithmus, um die geschätzten Werte Ex| = {Exn} (n = 1, 2, ..., N) von Übertragungssymbolfolgen aus den Abtastwertfolgen y| anhand der geschätzten Werte E|h zu erhalten, **gekennzeichnet durch**

Erhalten einer Abtastphase $\tau$S anhand der ausgewählten Abtastphase, die **durch** die Auswahleinrichtung erhalten wird, derart, daß die Bitfehlerrate minimal ist,

Abtasten der Empfangssignale y(t), die zu spezifizierten Zeitpunkten in bezug auf ein Symbolintervall T und die Abtastphase $\tau$s eingegeben werden, um Abtastwertfolgen y| = {yn} (n = 1, 2, ..., N) zu erhalten.

**15.** Verfahren zum Schätzen von Maximalwahrscheinlichkeitsfolgen nach Anspruch 14, das umfaßt:

Erhalten eines Index Ik aus der mit $\tau$(Ik) bezeichneten ausgewählten Abtastphase und

Erhalten eines gewichteten Mittelwerts, eines Maximalwerts und einen Minimalwerts des Index Ik und Erhalten eines Index Is, indem der Minimalwert vom Maximalwert subtrahiert wird, um einen ersten Ergebniswert zu erhalten, der erste Ergebniswert mit einer Konstanten multipliziert wird, um einen zweiten Ergebniswert zu erhalten, und der zweite Ergebniswert zum gewichteten Mittelwert addiert wird, wobei die Abtastphase $\tau$s dem Index Is entspricht.

**16.** Verfahren zum Schätzen von Maximalwahrscheinlichkeitsfolgen nach Anspruch 15, das umfaßt: Erhalten eines gewichteten Mittelwerts, eines Maximalwerts und eines Minimalwerts des Index Ik in jedem vorgegebenen Abschnitt.

**17.** Verfahren zum Schätzen von Maximalwahrscheinlichkeitsfolgen nach Anspruch 14, das umfaßt:

Abtasten der Empfangssignale y(t) in einem Symbolintervall T in bezug auf entsprechende Abtastphasen einfacher nicht zunehmender oder einfacher nicht abnehmender Abtastphasenfolgen $\tau\{\tau(i)\}$ (i = 1, 2, ..., M), um die Abtastwertfolgen y|i zu erhalten, und

Erhalten der komplexen Kreuzkorrelationsfunktionen Ci der Trainingsfolgen $\phi|$ gemäß der folgenden Gleichung:

$$\mathtt{Ci} = \sum_{j=1}^{Nt} \mathtt{yij}\left(\Phi \mathtt{j}^{\star}\right)$$

(wobei i = 1, 2, ..., M: * bedeutet, daß die Komplexkonjugation verwendet wird)

**18.** Verfahren zum Schätzen von Maximalwahrscheinlichkeitsfolgen nach Anspruch 17, das umfaßt: Erhalten

(1) des gewichteten Mittelwerts, des Maximalwerts und des Minimalwerts des Index Ik für jeden vorgegebenen Abschnitt als einen gewichteten Abschnittsmittelwert I avg (k) bzw. einen Abschnittsmaximalwert I max (k) bzw. einen Abschnittsminimalwert I min (k) des Index Ik, die zum Zeitpunkt der Auswahl der k-ten Abtastphase gemäß den folgenden Gleichungen berechnet werden:

$$\mathtt{I\ max\ (k)} = \begin{cases} \max_{1 \leq j \leq k} \mathtt{Ij} & \mathtt{k < Ls} \\ \max_{k-Ls+1 \leq j \leq k} \mathtt{Ij} & \mathtt{k \geq Ls} \end{cases}$$

$$I \min (k) = \begin{cases} \min_{1 \leq j \leq k} I_j & k < L_s \\ \min_{k-L_s+1 \leq j \leq k} I_j & k \geq L_s \end{cases}$$

$$I \text{ avg } (k) = \begin{cases} \dfrac{\sum_{j=1}^{k} (w_a(k - j + 1)I_j)}{\sum_{j=1}^{k} w_a(j)} & k < L_s \\[4mm] \dfrac{\sum_{j=k-L_s+1}^{k} (w_a(k - j + 1)I_j)}{\sum_{j=1}^{L_s} w_a(j)} & k > L_s \end{cases}$$

(wobei wa(j) (j = 1, 2, ..., Ls) ein gewichteter Koeffizient ist und Ls die maximale Länge der Berechnung bezeichnet),
(2) eines selektiven Abtastphasenindex Is gemäß der folgenden Gleichung:

$$I_s = [I \text{ avg } (k) + w_s (I \max (k) - I \min (k))]$$

(wobei [ ] die Gaußsche Notation angibt, die die größte ganze Zahl, die einen Wert in der Notation nicht übersteigt, bezeichnet, und ws einen Verschiebungskoeffizienten bezeichnet),
und
(3) der Abtastphase τs, die dem Index Is entspricht, gemäß der folgenden Gleichung:

$$\tau = \begin{cases} \tau(1) & I_s < 1 \\ \tau(I_s) & 1 \leq I_s \leq M. \\ \tau(M) & M < I_s \end{cases}$$

**19.** Verfahren zum Schätzen von Maximalwahrscheinlichkeitsfolgen nach Anspruch 16, das umfaßt: Erhalten

(1) des gewichteten Mittelwerts, des Maximalwerts und des Minimalwerts des Index Ik für jeden vorgegebenen Abschnitt als einen gewichteten Mittelwert I AVG (k) bzw. einen Maximalwert I MAX (k) bzw. einen Minimalwert I MIN (k) des Index Ik, der zum Zeitpunkt der Auswahl der k-ten Abtastphase gemäß den folgenden Gleichungen berechnet wird:

$$I \text{ MAX } (k) = \max_{1 \leq j \leq k} I_j$$

$$I \; MIN \; (k) \; = \; \min_{1 \leq j \leq k} Ij$$

$$I\,AVG\,(k) = (1 - \alpha)\,I\,AVG\,(k - 1) + \alpha Ik$$

($\alpha$: Konstante)

$$I\,AVG\,(0) = 0$$

(2) eines selektiven Abtastphasenindex Is gemäß der folgenden Gleichung:

$$Is = [I\,AVG\,(k) + ws(I\,MAX\,(k) - I\,MIN\,(k))]$$

(wobei [ ] die Gaußsche Notation angibt, die die größte ganze Zahl, die einen Wert in der Notation nicht übersteigt, bezeichnet, und ws einen Verschiebungskoeffizienten bezeichnet), und
(3) der Abtastphase $\tau$s, die dem Index Is entspricht, gemäß der folgenden Gleichung:

$$\tau \; = \; \begin{cases} \tau(1) & Is < 1 \\ \tau(Is) & 1 \leq Is \leq M \\ \tau(M) & M < Is \end{cases}.$$

**20.** Verfahren zum Schätzen von Maximalwahrscheinlichkeitsfolgen nach Anspruch 19, das umfaßt: Erhalten eines gewichteten Abschnittsmittelwerts, eines Abschnittsmaximalwerts und eines Abschnittsminimalwerts sämtlich aus einer Abtastphase $\tau$sel(k), die ihrerseits von der Auswahleinrichtung als die ausgewählte Abtastphase erhalten wird, und Erhalten der Abtastphase $\tau$s anhand des gewichteten Abschnittsmittelwerts, des Abschnittsmaximalwerts und des Abschnittsminimalwerts.

**21.** Verfahren zum Schätzen von Maximalwahrscheinlichkeitsfolgen nach Anspruch 20, das umfaßt:

Abtasten der Empfangssignale in dem Symbolintervall T, wobei zu einem geschätzten Anfangszeitpunkt, der durch einen Rahmensynchronisationsmechanismus bestimmt wird, begonnen wird,
Erhalten eines Koordinatentransformationsterms gemäß dem geschätzten Anfangszeitpunkt, Addieren des Koordinatentransformationsterms zu der Abtastphase $\tau$sel(k), Erhalten des gewichteten Abstandsmittelwerts, eines Abschnittsmaximalwerts und eines Abschnittsminimalwerts der Abtastphase $\tau$sel(k), nachdem der Koordinatentransformationsterm zur Abtastphase $\tau$sel(k) addiert worden ist, und Berechnen der Abtastphase $\tau$s durch Subtrahieren des Koordinatentransformationsterms vom gewichteten Abstandsmittelwert bzw. durch Addieren eines zweiten Ergebniswerts zum gewichteten Abschnittsmittelwert, wobei der zweite Ergebniswert erhalten wird durch:

(1) Subtrahieren des Absolutwerts des Koordinatentransformationsterms und des Abschnittsmittelwerts vom Abschnittsmaximalwert, um einen ersten Ergebniswert zu erhalten, und
(2) Multiplizieren des ersten Ergebniswerts mit einer Konstanten, um den zweiten Ergebniswert zu erhalten.

**22.** Verfahren zum Schätzen von Maximalwahrscheinlichkeitsfolgen nach Anspruch 21, das umfaßt:

Abtasten der Empfangssignale in dem Symbolintervall T in bezug auf die jeweiligen Abtastphasen der Abtastphasenfolgen $\tau = \{x(i)\}$ (i = 1, 2, ..., M) beginnend bei einem geschätzten Anfangszeitpunkt Et slot (k), der durch einen Rahmensynchronisationsmechanismus bestimmt ist, wenn der k-te zugewiesene Zeitschlitz verarbeitet wird, um Abtastwertfolgen $y|_i = \{y_{in}\}$ (i = 1, 2, ..., M; n = 1, 2, ..., Nt) der Empfangssignale zu erhalten, Erhalten der komplexen Kreuzkorrelationsfunktionen Ci der Trainingsfolgen anhand der Abtastwertfolgen $y|_i$ und der Trainingsfolgen $\phi| = \{\phi_n\}$ (n = 1, 2, ..., Nt) der Abtastwertfolgen yi gemäß der folgenden Gleichung:

$$\text{Ci} = \sum_{j=1}^{Nt} \text{yij}\left(\Phi j^{*}\right)$$

(wobei i = 1, 2, ..., M; * bedeutet, daß die Komplexkonjugation verwendet wird),
und
Erhalten:

(a) des Koordinatentransformationsterms als einen Koordinatentransformationsterm tc(k) gemäß der im folgenden angegebenen Gleichungen:

$$\Delta tc(k) = Et\ slot\ (k) - Et\ slot\ (k - 1) \qquad k > 1$$

$$\text{tc(k)} = \begin{bmatrix} \sum_{i=1}^{k-1} \Delta \text{tc(i)} & k > 1 \\ 0 & k = 1 \end{bmatrix}$$

(b) des gewichteten Abstandsmittelwerts, des Abschnittsmaximalwerts und des Abschnittsminimalwerts als einen gewichteten Abstandsmittelwert $\tau$ avg (k) bzw. einen Abschnittsmaximalwert $\tau$ max (k) bzw. einen Abschnittsminimalwert $\tau$ min (k) der Abtastphase $\tau$sel(k) gemäß den folgenden Gleichungen:

$$\tau\ \max\ (k) = \begin{bmatrix} \max_{1 \leq j \leq k} \left(\tau sel(j) + tc(j)\right) & k < Ls \\ \max_{k-Ls+1 \leq j \leq k} \left(\tau sel(j) + tc(j)\right) & k \geq Ls \end{bmatrix}$$

$$\tau\ \min\ (k) = \begin{bmatrix} \min_{1 \leq j \leq k} \left(\tau sel(j) + tc(j)\right) & k < Ls \\ \min_{k-Ls+1 \leq j \leq k} \left(\tau sel(j) + tc(j)\right) & k \geq Ls \end{bmatrix}$$

$$\tau\ avg\ (k)\ =\ \begin{cases} \dfrac{\displaystyle\sum_{j=1}^{k} \left(wa(k - j + 1)(\tau sel(j) + tc(j))\right)}{\displaystyle\sum_{j=1}^{k} wa(j)} & k < Ls \\[4em] \dfrac{\displaystyle\sum_{j=k-Ls+1}^{k} \left(wa(k - j + 1)(\tau sel(j) + tc(j))\right)}{\displaystyle\sum_{j=1}^{Ls} wa(j)} & k > Ls \end{cases}$$

(wobei wa(j) (j = 1, 2, ..., Ls) ein gewichteter Koeffizient ist und Ls die maximale Berechnungslänge bezeichnet),

und

(c) der selektiven Abtastphase $\tau$s gemäß der folgenden Gleichung:

$$\tau s = \tau\ avg\ (k) - tc(k) + ws(\tau max(k) - \tau min(k) - |tc(k)|)$$

(wobei ws den Verschiebungskoeffizienten angibt, wa(j) (j = 1, 2, ..., Ls) ein gewichteter Koeffizient ist und Ls die maximale Berechnungslänge bezeichnet).

**23.** Verfahren zum Schätzen von Maximalwahrscheinlichkeitsfolgen nach Anspruch 20, das umfaßt:

Abtasten der Empfangssignale in dem Symbolintervall T, wobei bei einem geschätzten Anfangszeitpunkt begonnen wird, der durch einen Rahmensynchronisationsmechanismus bestimmt wird, und

Erhalten erster und zweiter Koordinatentransformationsterme gemäß dem geschätzten Anfangszeitpunkt, Addieren des zweiten Koordinatentransformationsterms zur Abtastphase $\tau$sel(k), Erhalten des gewichteten Abschnittsmittelwerts, des Abschnittsmaximalwerts und des Abschnittsminimalwerts der Abtastphase $\tau$sel (k) nach der Addition des zweiten Koordinatentransformationsterms zur Abtastphase $\tau$sel(k) und Berechnen der Abtastphase $\tau$sel durch Subtrahieren des Abschnittsminimalwerts bzw. des Absolutwerts des ersten Koordinatentransformationsterms vom Abschnittsmaximalwert, um einen ersten Ergebniswert zu erhalten, durch Multiplizieren des ersten Ergebniswerts mit einer Konstanten, um einen zweiten Ergebniswert zu erhalten, und durch Addieren des zweiten Ergebniswerts zum gewichteten Abschnittsmittelwert.

**24.** Verfahren zum Schätzen von Maximalwahrscheinlichkeitsfolgen nach Anspruch 22, das umfaßt:

Abtasten der Empfangssignale, die con den Übertragungsleitungen eingegeben werden, in dem Symbolintervall T in bezug auf die jeweiligen Abtastphasen der Abtastphasenfolgen $\tau$ = {$\tau$(i)} (i = 1, 2, ..., M), wobei bei dem geschätzten Anfangszeitschlitz Et slot (k) begonnen wird, der durch den Rahmensynchronisationsmechanismus bestimmt wird, wenn der k-te zugewiesene Zeitschlitz verarbeitet wird, um die Abtastwertfolgen y|i = {yin} (i = 1, 2, ..., M; n = 1, 2, ..., Nt) der Empfangssignale yt zu erhalten,

Erhalten der komplexen Kreuzkorrelationsfunktion Ci der Trainingsfolgen $\phi$| anhand der Abtastwertfolgen y|i und der Trainingsfolgen $\phi$| = {$\phi$n} (n = 1, 2, ..., Nt) der Abtastwertfolgen y|i gemäß der folgenden Gleichung:

$$Ci\ =\ \sum_{j=1}^{Nt} yij\left(\Phi j^{*}\right)$$

(wobei i = 1, 2, ..., M; * bedeutet, daß die Komplexkonjugation verwendet wird),

und
Erhalten

(a) der ersten und zweiten Koordinatentransformationsterme als einen ersten Koordinatentransformationsterm tc1(k) bzw. einen zweiten Koordinatentransformationsterm tc2(j,k) zum Zeitpunkt der Auswahl der k-ten Abtastphase gemäß den folgenden Gleichungen:

$$\Delta tc(k) = \begin{bmatrix} Et\,slot\,(k) - Et\,slot\,(k-1) & k > 1 \\ 0 & k \leq 1 \\ 0 & k \leq 1 \end{bmatrix}$$

$$tc1(k) = \begin{bmatrix} \sum_{i=1}^{k-1} \Delta tc(i+1) & k < Ls \\ \sum_{i=k-Ls}^{k-1} \Delta tc(i+1) & k \geq Ls \end{bmatrix}$$

$$tc2(j,k) = \begin{bmatrix} \sum_{i=j}^{k-1} \Delta tc(i+1) & j < k \\ 0 & j \geq k \end{bmatrix}$$

(b) des gewichteten Abschnittsmittelwerts, des Abschnittsmaximalwerts und des Abschnittsminimalwerts als einen gewichteten Abschnittsmittelwert $\tau$ AVG (k) bzw. einen Abschnittsmaximalwert $\tau$ MAX (k) bzw. einen Abschnittsminimalwert $\tau$ MIN (k) der Abtastphase $\tau$sel(k) gemäß den folgenden Gleichungen:

$$\tau\,MAX\,(k) = \begin{bmatrix} \max_{1 \leq j \leq k} (\tau sel(j) + tc2(j,k)) & k < Ls \\ \max_{k-Ls+1 \leq j \leq k} (\tau sel(j) + tc2(j,k)) & k \geq Ls \end{bmatrix}$$

$$\tau\,MIN\,(k) = \begin{bmatrix} \min_{1 \leq j \leq k} (\tau sel(j) + tc2(j,k)) & k < Ls \\ \min_{k-Ls+1 \leq j \leq k} (\tau sel(j) + tc2(j,k)) & k \geq Ls \end{bmatrix}$$

$$\tau\,\text{AVG}\,(k) = \begin{cases} \dfrac{\displaystyle\sum_{j=1}^{k}\big(\mathtt{wa}(k-j+1)(\tau\mathtt{sel}(j)+\mathtt{tc2}(j,k))\big)}{\displaystyle\sum_{j=1}^{k}\mathtt{wa}(j)} & k < \mathtt{Ls} \\[4ex] \dfrac{\displaystyle\sum_{j=k-\mathtt{Ls}+1}^{k}\big(\mathtt{wa}(k-j+1)(\tau\mathtt{sel}(j)+\mathtt{tc2}(j,k))\big)}{\displaystyle\sum_{j=1}^{\mathtt{Ls}}\mathtt{wa}(j)} & k \geq \mathtt{Ls} \end{cases}$$

(wobei $wa(j)$ ($j$ = 1, 2, ..., Ls) ein Gewichtungskoeffizient ist und Ls die maximale Berechnungslänge bezeichnet),
und
(c) der ausgewählten Abtastphase $\tau s$ gemäß der folgenden Gleichung:

$$\tau s = \tau\,\text{MAX}\,(k) + ws\,(\tau\,\text{MAX}\,(k) - \tau\,\text{MIN}\,(k) - |tc1(k)|)$$

(wobei ws den Verschiebungskoeffizienten angibt, $wa(j)$ ($j$ = 1, 2, ..., Ls) ein Gewichtungskoeffizient ist und Ls die maximale Berechnungslänge bezeichnet).

25. Verfahren nach Anspruch 18, 19, 21 oder 23, das umfaßt:

Verzögern der Empfangssignale,
Abtasten der verzögerten Empfangssignale,
Erhalten erster geschätzter Werte $E|h = \{Ehj\}$ ($j$ = 0, 1, ..., L) der Impulsantworten des Übertragungspfades aus den Abtastwertfolgen $y|$ und aus Trainingsfolgen $\phi|$, die den Abtastwertfolgen $y|$ entsprechen, gemäß einem adaptiven Angleichungsalgorithmus,
Erhalten geschätzter Werte Eh aus den Abtastwertfolgen $y|$ und geschätzter Werte $E|x = \{Exn\}$ ($n$ = 1, 2, ..., N) der Übertragungssymbolfolgen gemäß dem adaptiven Angleichungsalgorithums und
Erhalten der geschätzten Werte $E|x$ gemäß einem Viterbi-Algorithmus.

**Revendications**

1. Estimateur de séquence à vraisemblance maximale comprenant :

des moyens d'échantillonnage (101-1, 101-M) pour échantillonner des signaux de réception y(t) provenant d'une voie de transmission, à un intervalle de symbole T en relation avec des phases d'échantillonnage respectives de séquences de phases d'échantillonnage $\tau = \{\tau(i)\}$ ($i$ = 1, 2, ... M), pour obtenir des séquences de valeurs d'échantillons $y_i = \{yin\}$ ($i$ = 1, 2, ..., M; $n$ = 1, 2, ..., Nt) des signaux de réception y(t),
des moyens de calcul de valeur de corrélation (102-1, 102-M) pour obtenir des fonctions d'intercorrélation complexes $c = \{Ci\}$ ($i$ = 1, 2, ..., M) des séquences de valeurs d'échantillons $y_i$ et des séquences d'apprentissage $\phi = \{\phi n\}$ ($n$ = 1, 2, ..., Nt) des séquences de valeurs d'échantillons $y_i$, et
des moyens de sélection (103, 302) pour obtenir une phase d'échantillonnage sélectionnée à laquelle les valeurs absolues du nombre M de fonctions d'intercorrélation complexes Ci sont maximisées, en comparant les valeurs absolues;
une section d'estimation de voie de transmission (140) pour obtenir des valeurs estimées $E|h = \{Ehj\}$ ($j$ = 0, 1, ..., L) de réponses impulsionnelles de la voie de transmission, conformément à un algorithme d'égalisation adaptative, en relation avec les séquences de valeurs d'échantillons $y$ et les séquences d'apprentissage $\phi$ qui leur correspondent, et à partir de valeurs estimées $Ex$ des séquences de symboles de transmission et des séquences de valeurs d'échantillons $y$ ; et

une section de traitement d'algorithme de Viterbi (130) pour obtenir les valeurs estimées $\mathbf{E}\mathbf{y}$ = {Exn} (n = 1, 2, ..., N) de séquences de symboles de transmission à partir des séquences de valeurs d'échantillons $\mathbf{y}$ sur la base des valeurs estimées **E|h, caractérisé par**

des moyens de lissage de phase d'échantillonnage (104, 201, 301, 401) pour obtenir une phase d'échantillonnage $\tau$s sur la base de la phase d'échantillonnage sélectionnée obtenue par les moyens de sélection, de façon à minimiser le taux d'erreurs de bit,

une section de traitement d'échantillonnage (120) pour échantillonner les signaux de réception y(t) introduits à des instants spécifiés par rapport à un intervalle de symbole T et à la phase d'échantillonnage $\tau$s, pour obtenir des séquences de valeurs d'échantillons $\mathbf{y}$ = {yn} (n = 1, 2, ..., N).

2. Estimateur de séquence à vraisemblance maximale selon la revendication 1, dans lequel :

les moyens de sélection (103) sont configurés pour obtenir un index Ik à partir de la phase d'échantillonnage sélectionnée désignée par $\tau$(Ik), et

les moyens de lissage de phase d'échantillonnage (104) sont adaptés pour obtenir une valeur moyenne pondérée, une valeur maximale et une valeur minimale de l'index Ik, et pour obtenir un index Is en soustrayant la valeur minimale de la valeur maximale pour obtenir une première valeur résultante, en multipliant la première valeur résultante par une constante pour obtenir une seconde valeur résultante, et en additionnant la seconde valeur résultante à la valeur moyenne pondérée, la phase d'échantillonnage $\tau$s correspondant à l'index Is.

3. Estimateur de séquence à vraisemblance maximale selon la revendication 2, dans lequel les moyens de lissage de phase d'échantillonnage (104) peuvent fonctionner de façon à obtenir une valeur moyenne pondérée, une valeur maximale et une valeur minimale de l'index Ik pour chaque section prédéterminée.

4. Estimateur de séquence à vraisemblance maximale selon la revendication 2 ou 3, dans lequel :

les moyens d'échantillonnage (101) sont configurés pour échantillonner les signaux de réception y(t) à un intervalle de symbole T en relation avec des phases d'échantillonnage respectives de séquences de phases d'échantillonnage non croissantes simples ou non décroissantes simples $\tau$={$\tau$(i)} (i = 1, 2, ... M), pour obtenir les séquences de valeurs d'échantillons $\mathbf{y}$ i, et

les moyens de calcul de valeurs de corrélation (102) peuvent fonctionner de façon à obtenir les fonctions d'intercorrélation complexes Ci des séquences d'apprentissage $\phi$, conformément à l'équation suivante :

$$Ci = \sum_{j=1}^{Nt} yij(\Phi j*)$$

(avec i = 1, 2, ..., M; * signifie qu'on utilise la conjugaison complexe).

5. Estimateur de séquence à vraisemblance maximale selon la revendication 4, dans lequel :

les moyens de lissage de phase d'échantillonnage (104) sont adaptés pour obtenir

(1) la valeur moyenne pondérée, la valeur maximale et la valeur minimale de l'index Ik pour chaque section prédéterminée, respectivement sous la forme d'une valeur moyenne pondérée de section I avg (k), d'une valeur maximale de section I max (k) et d'une valeur minimale de section I min (k) de l'index Ik, calculées conformément aux équations suivantes, au moment de la k-ième sélection de phase d'échantillonnage :

$$Imax(k) = \begin{cases} \max_{1 \le j \le k} Ij & k < Ls \\ \max_{k - Ls + 1 \le j \le k} Ij & k \ge Ls \end{cases}$$

$$Imin(k) = \begin{cases} \min_{1 \le j \le k} Ij & k < Ls \\ \min_{k - Ls + 1 \le j \le k} Ij & k \ge Ls \end{cases}$$

$$Iavg(k) = \begin{cases} \dfrac{\sum_{j=1}^{k} \{wa\ (k - j + 1)\ Ij\}}{\sum_{j=1}^{k} wa\ (j)} & k < Ls \\[4ex] \dfrac{\sum_{j=k-Ls+1}^{k} \{wa\ (k - j + 1)\ Ij\}}{\sum_{j=1}^{Ls} wa\ (j)} & k \ge Ls \end{cases}$$

(en désignant par wa (j) (j = 1, 2, ..., Ls) un coefficient de pondération et par Ls la longueur de calcul maximale),
(2) un index de phase d'échantillonnage sélectif Is conformément à l'équation suivante :

$$Is = [I\ avg\ (k) + ws\ (I\ max\ (k) - I\ min\ (k))]$$

(avec les notations suivantes : [ ] représente la notation de Gauss qui retourne le plus grand entier ne dépassant pas une valeur dans la notation, et ws désigne un coefficient de décalage),
et
(3) la phase d'échantillonnage $\tau s$ correspondant à l'index Is conformément à l'équation suivante :

$$\tau s = \begin{cases} \tau\ (1) & Is < 1 \\ \tau\ (Is) & 1 \le Is \le M \\ \tau\ (M) & M < Is \end{cases}$$

**6.** Estimateur de séquence à vraisemblance maximale selon la revendication 4, dans lequel :

les moyens de lissage de phase d'échantillonnage (104) sont adaptés pour obtenir

(1) la valeur moyenne pondérée, la valeur maximale et la valeur minimale de l'index Ik pour chaque section prédéterminée, respectivement sous la forme d'une valeur moyenne pondérée I AVG (k), d'une valeur maximale I MAX (k) et d'une valeur minimale I MIN (k) de l'index Ik, calculées conformément aux équations suivantes au moment de la k-ième sélection de phase d'échantillonnage :

$$I\ MAX(k)\ =\ \begin{array}{c} \max \\ 1 \le j \le k \end{array}\ Ij$$

$$I\ MIN(k)\ =\ \begin{array}{c} \min \\ 1 \le j \le k \end{array}\ Ij$$

I AVG(k= = 1 - $\alpha$) I AVG (k - 1) + $\alpha$Ik ($\alpha$ : constante)

I AVG(O) = 0

(2) un index de phase d'échantillonnage sélectif Is conformément à l'équation suivante :

Is = [I AVG (k) + ws (I MAX (k) - I MIN (k) ) ]

(avec les notations suivantes : [ ] représente la notation de Gauss qui retourne le plus grand entier ne dépassant pas une valeur dans la notation, et ws désigne un coefficient de décalage),
et
(3) la phase d'échantillonnage $\tau$s correspondant à l'index Is conformément à l'équation suivante :

$$\tau s\ =\ \begin{cases} \tau\ (1) & Is < 1 \\ \tau\ (Is) & 1 \le Is \le M \\ \tau\ (M) & M < Is \end{cases}$$

7. Estimateur de séquence à vraisemblance maximale selon la revendication 5 ou 6, comprenant en outre une section de traitement de retard (110) pour retarder les signaux de réception introduits à partir des lignes de transmission, de la durée qui est spécifiée, et pour émettre les signaux vers la section de traitement d'échantillonnage, dans lequel :

la section de traitement d'échantillonnage (120) peut fonctionner de façon à échantillonner les signaux de réception provenant de la section de traitement de retard,
la section d'estimation de transmission (140) est adaptée pour obtenir des premières valeurs estimées **E|h** = {Ehj} (j = 0, 1, ..., L) des réponses impulsionnelles des lignes de transmission, à partir des séquences de valeurs d'échantillons **Y/**, et des séquences d'apprentissage $\phi$ correspondant aux séquences de valeurs d'échantillons **Y/**, conformément à un algorithme d'égalisation adaptative,
la section d'estimation de transmission (140) est adaptée pour obtenir des secondes valeurs estimées Eh à partir des séquences de valeurs d'échantillons **y** et des valeurs estimées **Ex** = {Exn} (n = 1, 2, ..., N) des séquences de symboles de transmission, conformément à l'algorithme d'égalisation adaptative, et
la section de traitement d'opération (130) peut fonctionner de manière à obtenir les valeurs estimées **Ex** conformément à un algorithme de Viterbi.

8. Estimateur de séquence à vraisemblance maximale selon la revendication 1, dans lequel les moyens de lissage de phase d'échantillonnage (301) sont adaptés pour obtenir une valeur moyenne pondérée de section, une valeur maximale de section et une valeur minimale de section, portant toutes sur une phase d'échantillonnage $\tau$sel(k) obtenue sous la forme de la phase d'échantillonnage sélectionnée par les moyens de sélection, et pour obtenir la phase d'échantillonnage τs sur la base de la valeur moyenne pondérée de section, de la valeur maximale de section et de la valeur minimale de section.

**9.** Estimateur de séquence à vraisemblance maximale selon la revendication 8, dans lequel :

les moyens d'échantillonnage (101) sont adaptés pour échantillonner les signaux de réception à l'intervalle de symbole T, en partant d'un instant de début estimé qui est déterminé par un mécanisme de synchronisation de trame,

les moyens de lissage de phase d'échantillonnage sont adaptés pour obtenir un terme de transformation de coordonnées conformément à l'instant de début estimé, additionner le terme de transformation de coordonnées à la phase d'échantillonnage τsel(k), obtenir la valeur moyenne pondérée de section, une valeur maximale de section et une valeur minimale de section de la phase d'échantillonnage τsel(k) après l'addition du terme de transformation de coordonnées à la phase d'échantillonnage τsel(k), et calculer la phase d'échantillonnage τs respectivement en soustrayant de la valeur moyenne pondérée de section et en additionnant à celle-ci le terme de transformation de coordonnées et une seconde valeur résultante, la seconde valeur résultante étant obtenue en

(1) soustrayant la valeur absolue du terme de transformation de coordonnées, et la valeur minimale de section, de la valeur maximale de section pour obtenir une première valeur résultante, et

(2) multipliant la première valeur résultante par une constante pour obtenir la seconde valeur résultante.

**10.** Estimateur de séquence à vraisemblance maximale selon la revendication 9, dans lequel :

les moyens d'échantillonnage (10) sont adaptés pour échantillonner les signaux de réception à l'intervalle de symbole T en relation avec les phases d'échantillonnage respectives des séquences de phases d'échantillonnage $\tau = \{\tau (i)\}$ (i = 1, 2, ..., M), en partant d'un instant de début estimé Et slot (k) déterminé par un mécanisme de synchronisation de trame, au moment du traitement du k-ième créneau temporel assigné, pour obtenir des séquences de valeurs d'échantillons $\mathbf{y}_i = \{yin\}$ (i = 1, 2, ..., M; N = 1, 2, ..., Nt) des signaux de réception,

les moyens de calcul de valeur de corrélation (102) sont configurés pour obtenir les fonctions d'intercorrélation complexes Ci des séquences d'apprentissage sur la base des séquences de valeurs d'échantillons $\mathbf{y}_i$ et des séquences d'apprentissage $\boldsymbol{\Phi} = \{\phi n\}$ (n = 1, 2, ..., Nt) des séquences de valeurs d'échantillons yi, conformément à l'équation suivante :

$$Ci = \sum_{j=1}^{Nt} yij(\Phi j*)$$

(avec i = 1, 2, ..., M; et * indiquant que la conjugaison complexe est utilisée),
et
les moyens de lissage de phase d'échantillonnage sont adaptés pour obtenir

(a) le terme de transformation de coordonnées sous la forme d'un terme de transformation de coordonnées tc(k), conformément aux équations données ci-dessous :

$$\Delta tc(k) = Et\ slot\ (k) - Et\ slot\ (k-1) \qquad k > 1$$

$$tc(k) = \begin{cases} \sum_{i=1}^{k-1} \Delta tc\ (i) & k > 1 \\ \\ 0 & k = 1 \end{cases}$$

(b) la valeur moyenne pondérée de section, la valeur maximale de section et la valeur minimale de section, respectivement sous la forme d'une valeur moyenne pondérée de section $\tau$ avg (k), d'une valeur maximale de section $\tau$ max (k) et d'une valeur minimale de section $\tau$ min (k) de la phase d'échantillonnage $\tau$sel(k), conformément aux équations suivantes :

$$
\tau\,\mathrm{max}(k) = \begin{cases} \max_{1 \le j \le k} (\tau\mathrm{sel}(j) + tc\,(j)) & k < Ls \\[2ex] \max_{k - Ls + 1 \le j \le k} (\tau\mathrm{sel}(j) + tc\,(j)) & k \ge Ls \end{cases}
$$

$$
\tau\,\mathrm{min}(k) = \begin{cases} \min_{1 \le j \le k} (\tau\mathrm{sel}(j) + tc\,(j)) & k < Ls \\[2ex] \min_{k - Ls + 1 \le j \le k} (\tau\mathrm{sel}(j) + tc\,(j)) & k \ge Ls \end{cases}
$$

$$
\tau\,\mathrm{avg}(k) = \begin{cases} \dfrac{\displaystyle\sum_{j=1}^{k} (wa\,(k - j + 1)\,(\tau\mathrm{sel}(j) + tc\,(j)))}{\displaystyle\sum_{j=1}^{k} wa\,(j)} & k < Ls \\[5ex] \dfrac{\displaystyle\sum_{j=k-Ls+1}^{k} (wa\,(k - j + 1)\,(\tau\mathrm{sel}(j) + tc(j)))}{\displaystyle\sum_{j=1}^{Ls} wa\,(j)} & k \ge Ls \end{cases}
$$

(avec les notations suivantes : wa (j= (j = 1, 2, ..., Ls) est un coefficient de pondération et Ls désigne la longueur de calcul maximale),
et
(c) la phase d'échantillonnage sélective $\tau$s conformément à l'équation suivante :

$$
\tau s = \tau\,\mathrm{avg}(k) - tc(k) + ws\,(\tau\mathrm{max}(k) - \tau\mathrm{min}(k) - |tc\,(k)|)
$$

(avec les notations suivantes : ws indique le coefficient de décalage, wa (j) (j = 1, 2, ..., Ls) est un coefficient de pondération, et Ls désigne la longueur de calcul maximale).

**11.** Estimateur de séquence à vraisemblance maximale selon la revendication 8, dans lequel :

les moyens d'échantillonnage (101) sont adaptés pour échantillonner les signaux de réception à l'intervalle de symbole T, en partant d'un instant de début estimé déterminé par un mécanisme de synchronisation de trame, et

les moyens de lissage de phase d'échantillonnage (301) sont adaptés pour obtenir des premier et second termes de transformation de coordonnées conformément à l'instant de début estimé, additionner le second terme de transformation de coordonnées à la phase d'échantillonnage $\tau$sel(k), pour obtenir la valeur moyenne pondérée de section, la valeur maximale de section et la valeur minimale de section de la phase d'échantillonnage $\tau$sel(k), après l'addition du second terme de transformation de coordonnées à la phase d'échantillonnage $\tau$sel(k), et calculer la phase d'échantillonnage $\tau$sel en soustrayant respectivement la valeur minimale de section et la valeur absolue du premier terme de transformation de coordonnées de la valeur maximale de section, pour obtenir une première valeur résultante, en multipliant la première valeur résultante par une constante pour obtenir une seconde valeur résultante, et en additionnant la seconde valeur résultante à la valeur moyenne pondérée de section.

**12.** Estimateur de séquence à vraisemblance maximale selon la revendication 11, dans lequel :

les moyens d'échantillonnage (101) sont adaptés pour échantillonner les signaux de réception, à l'intervalle de symbole T en relation avec les phases d'échantillonnage respectives des séquences de phases d'échantillonnage $\tau = \{\tau(i)\}$ (i = 1, 2, ..., M), en partant du créneau temporel de début estimé Et slot (k) déterminé par le mécanisme de synchronisation de trame, au moment du traitement du k-ième créneau temporel assigné, pour obtenir les séquences de valeurs d'échantillons $y$ i = {yin} (i = 1, 2, ..., M; n = 1, 2, ..., Nt) des signaux de réception y(t),

les moyens de calcul de valeur de corrélation (102) sont configurés pour obtenir une fonction d'intercorrélation complexe Ci des séquences d'apprentissage $\phi$ sur la base des séquences de valeurs d'échantillons yi et des séquences d'apprentissage $\phi$ = {$\phi$n} (n = 1, 2, ..., Nt) des séquences de valeurs d'échantillons $y$ i, conformément à l'équation suivante

$$Ci = \sum_{j=1}^{Nt} yij(\Phi j*)$$

(avec i = 1, 2, ..., M; et * indiquant qu'on utilise la conjugaison complexe),
et
les moyens de lissage de phase d'échantillonnage (401) sont configurés pour obtenir

(a) les premier et second termes de transformation de coordonnées, respectivement sous la forme d'un premier terme de transformation de coordonnées tc1(k) et d'un second terme de transformation de coordonnées tc2(j,k), conformément aux équations suivantes, au moment de la k-ième sélection de phase d'échantillon :

$$\Delta tc(k) = \begin{cases} Et\ slot\ (k) - \overline{Et}\ slot\ (k - 1) & k > 1 \\ 0 & k \leq 1 \\ 0 & k \leq 1 \end{cases}$$

$$tc1(k) = \begin{cases} \displaystyle\sum_{i=1}^{k-1} \Delta tc\ (i + 1) & k < Ls \\[2em] \displaystyle\sum_{i=k-Ls}^{k-1} \Delta tc\ (i + 1) & k \geq Ls \end{cases}$$

$$tc2(j,\ k) = \begin{cases} \displaystyle\sum_{i=j}^{k-1} \Delta tc\ (i + 1) & j < k \\[2em] 0 & j \geq k, \end{cases}$$

(b) la valeur moyenne pondérée de section, la valeur maximale de section et la valeur minimale de section, respectivement sous la forme d'une valeur moyenne pondérée de section $\tau$ AVG (k), d'une valeur maximale de section T MAX (k) et d'une valeur minimale de section $\tau$ MIN (k) de la phase d'échantillonnage $\tau$sel(k), conformément aux équations suivantes :

$$\tau\,MAX(k) = \begin{cases} \max_{1 \leq j \leq k} (\tau sel(j) + tc2(j,\ k)) & k < Ls \\[2em] \max_{k - Ls + 1 \leq j \leq k} (\tau sel(j) + tc2(j,\ k)) & k \geq Ls \end{cases}$$

$$\tau\,MIN(k) = \begin{cases} \min_{1 \leq j \leq k} (\tau sel(j) + tc2(j,\ k)) & k < Ls \\[2em] \min_{k - Ls + 1 \leq j \leq k} (\tau sel(j) + tc2(j,\ k)) & k \geq Ls \end{cases}$$

(avec les notations suivantes : wa (j) = (j = 1, 2, ..., Ls) est un coefficient de pondération et Ls désigne la longueur de calcul maximale),
et
(c) la phase d'échantillonnage de sélection $\tau$s conformément à l'équation suivante :

$$\tau s = \tau\ AVG\ (k) + ws\ (\tau MAX\ (k) - \tau\ MIN(k) - |tc1\ (k)\ |)$$

(avec les notations suivantes : ws indique le coefficient de décalage, wa (j) (j = 1, 2, ..., Ls) est un coefficient de pondération, et Ls désigne la longueur de calcul maximale).

13. Estimateur de fréquence à vraisemblance maximale selon la revendication 10, 11 ou 12, comprenant en outre une section de traitement de retard (110) pour retarder les signaux de réception et émettre les signaux vers la section de traitement d'échantillonnage, dans lequel :

les séquences de phases d'échantillonnage $\tau=\{\tau(i)\}$ (i = 1, 2, ..., M) dans les moyens d'échantillonnage sont simples non croissantes ou simples non décroissantes,

la section de traitement d'échantillonnage (120) peut fonctionner de façon à échantillonner les signaux de réception provenant de la section de traitement de retard,

la section d'estimation de transmission (140) est adaptée pour obtenir des premières valeurs estimées $E|h = \{Ehj\}$ (j = 0, 1, ..., L) des réponses impulsionnelles de la voie de transmission, à partir des séquences de valeurs d'échantillons $\mathbf{y}$, conformément à un algorithme d'égalisation adaptative,

la section d'estimation de transmission (140) est adaptée pour obtenir des valeurs estimées Eh à partir des séquences de valeurs d'échantillons $\mathbf{y}$ et des valeurs estimées $E\mathbf{x} = \{Exn\}$ (n = 1, 2, ... N) des séquences de symboles de transmission, conformément à l'algorithme d'égalisation adaptative, et

la section de traitement d'opération (130) peut fonctionner de façon à calculer les valeurs estimées $E\mathbf{x}$ conformément à un algorithme de Viterbi.

14. Procédé d'estimation de séquence à vraisemblance maximale comprenant :

l'échantillonnage de signaux de réception y(t) provenant d'une voie de transmission, à un intervalle de symbole T en relation avec des phases d'échantillonnage respectives de séquences de phases d'échantillonnage $\tau=\{\tau(i)\}$ (i = 1, 2, ... M), pour obtenir des séquences de valeurs d'échantillons $\mathbf{y}i = \{yin\}$ (i = 1, 2, ..., M; n = 1, 2, ..., Nt) des signaux de réception y(t)

l'obtention de fonctions d'intercorrélation complexes C = $\{Ci\}$ (i = 1, 2, ..., M) des séquences de valeurs d'échantillons yi et de séquences d'apprentissage ($\boldsymbol{\phi} = \{\phi n\}$ (n = 1, 2, ..., Nt) des séquences de valeurs complexes $\mathbf{y}i$, et

la sélection d'une phase d'échantillonnage à laquelle les valeurs absolues du nombre M de fonctions d'intercorrélation complexes Ci sont maximisées, en comparant les valeurs absolues;

l'obtention de valeurs estimées $E|h = \{Ehj\}$ (j = 0, 1, ..., L) de réponses impulsionnelles de la voie de transmission, conformément à un algorithme d'égalisation adaptative, en relation avec les séquences de valeurs d'échantillons $\mathbf{y}$ et les séquences d'apprentissage $\boldsymbol{\phi}$ qui leur correspondent, et à partir de valeurs estimées $E\mathbf{x}$ des séquences de symboles de transmission et des séquences de valeurs d'échantillons $\mathbf{y}$ et

l'utilisation de l'algorithme de Viterbi pour obtenir les valeurs estimées $E\mathbf{x} = \{Exn\}$ (n = 1, 2, ..., N) de séquences de symboles de transmission, à partir des séquences de valeurs d'échantillons $\mathbf{y}$, sur la base des valeurs estimées $E|h$, **caractérisé par**

l'obtention d'une phase d'échantillonnage $\tau s$ basée sur la phase d'échantillonnage sélectionnée, de façon que le taux d'erreurs de bit soit minimisé,

l'échantillonnage des signaux de réception y(t) introduits à des instants spécifiés en relation avec un intervalle de symbole T et la phase d'échantillonnage $\tau s$, pour obtenir des séquences de valeurs d'échantillons $\mathbf{y} = \{yn\}$ (n = 1, 2, ..., N) .

15. Un procédé selon la revendication 14, comprenant l'obtention d'un index Ik à partir de la phase d'échantillonnage sélectionnée, désignée par $\tau(Ik)$,

l'obtention d'une valeur moyenne pondérée, d'une valeur maximale et d'une valeur minimale de l'index Ik, l'obtention d'un index Is en soustrayant la valeur minimale de la valeur maximale pour obtenir une première valeur résultante, en multipliant la première valeur résultante par une constante pour obtenir une seconde valeur résultante, et en additionnant la seconde valeur résultante à la valeur moyenne pondérée, de façon à obtenir la phase d'échantillonnage $\tau s$ correspondant à l'index Is.

16. Procédé selon la revendication 15, comprenant l'obtention d'une valeur moyenne pondérée, d'une valeur maximale et d'une valeur minimale de l'index Ik pour chaque section prédéterminée.

17. Procédé selon la revendication 14, comprenant l'échantillonnage des signaux de réception y(t) à un intervalle de symbole T par rapport aux phases d'échantillonnage respectives de séquences de phases d'échantillonnage simples non croissantes ou simples non décroissantes $\tau=\{\tau(i)\}$ (i=1, 2, ... M), pour obtenir les séquences de valeurs d'échantillons $\mathbf{y}$ **i,** et

l'obtention des fonctions d'intercorrélation complexes Ci des séquences d'apprentissage $\boldsymbol{\phi}$, conformément à l'équation suivante

$$Ci = \sum_{j=1}^{Nt} yij(\Phi j*)$$

(avec i = 1, 2, ..., M; et * indiquant que la conjugaison complexe est utilisée).

**18.** Procédé selon la revendication 17, comprenant l'obtention de :

(1) la valeur moyenne pondérée, la valeur maximale et la valeur minimale de l'index Ik pour chaque section prédéterminée, respectivement sous la forme d'une valeur moyenne pondérée de section I avg (k), d'une valeur maximale de section I max (k) et d'une valeur minimale de section I min (k) de l'index Ik, calculées conformément aux équations suivantes au moment de la k-ième sélection de phase d'échantillonnage :

$$Imax(k) = \begin{cases} \max_{1 \le j \le k} Ij & k < Ls \\ \max_{k - Ls + 1 \le j \le k} Ij & k \ge Ls \end{cases}$$

$$Imin(k) = \begin{cases} \min_{1 \le j \le k} Ij & k < Ls \\ \min_{k - Ls + 1 \le j \le k} Ij & k \ge Ls \end{cases}$$

$$Iavg(k) = \begin{cases} \dfrac{\sum_{j=1}^{k} \{wa (k - j + 1) Ij\}}{\sum_{j=1}^{k} wa (j)} & k < Ls \\[20pt] \dfrac{\sum_{j=k-Ls+1}^{k} \{wa (k - j + 1) Ij\}}{\sum_{j=1}^{Ls} wa (j)} & k \ge Ls \end{cases}$$

(avec les notations suivantes : wa (j) (j = 1, 2, ..., Ls) est un coefficient de pondération et Ls désigne la longueur de calcul maximale),

(2) un index de phase d'échantillonnage sélectif Is conformément à l'équation suivante :

$$Is = [I\ avg\ (k) + ws\ (I\ max\ (k) - I\ min\ (k))]$$

(avec les notations suivantes : [ ] représente la notation de Gauss qui retourne le plus grand entier ne dépassant pas une valeur dans la notation, et ws désigne un coefficient de décalage),
et
(3) la phase d'échantillonnage τs correspondant à l'index Is conformément à l'équation suivante :

$$\tau s \;=\; \begin{cases} \tau\,(1) & Is < 1 \\ \tau\,(Is) & 1 \le Is \le M \\ \tau\,(M) & M < Is \end{cases}$$

**19.** Procédé selon la revendication 16, comprenant l'obtention de :

(1) la valeur moyenne pondérée, la valeur maximale et la valeur minimale de l'index Ik pour chaque section prédéterminée, respectivement sous la forme d'une valeur moyenne pondérée I AVG (k), d'une valeur maximale I MAX (k) et d'une valeur minimale I MIN (k) de l'index Ik, calculées conformément aux équations suivantes au moment de la k-ième sélection de phase d'échantillonnage :

$$I\ MAX(k) \;=\; \max_{1 \le j \le k}\ Ij$$

$$I\ MIN(k) \;=\; \min_{1 \le j \le k}\ Ij$$

$$I\ AVG(k) = (1 - \alpha)\ I\ AVG\ (k-1) + \alpha Ik\ (\alpha : \text{constante})$$

$$I\ AVG(O) = 0$$

(2) un index de phase d'échantillonnage sélectif Is conformément à l'équation suivante :

$$Is = [I\ AVG\ (k) + ws\ (I\ MAX\ (k) - I\ MIN\ (k))]$$

(avec les notations suivantes : [ ] représente la notation de Gauss qui retourne le plus grand entier ne dépassant pas une valeur dans la notation, et ws désigne un coefficient de décalage),
et
(3) la phase d'échantillonnage τs correspondant à l'index Is conformément à l'équation suivante :

$$\tau s \;=\; \begin{cases} \tau\,(1) & Is < 1 \\ \tau\,(Is) & 1 \le Is \le M \\ \tau\,(M) & M < Is \end{cases}$$

**20.** Procédé selon la revendication 19, comprenant l'obtention d'une valeur moyenne pondérée de section, d'une valeur maximale de section et d'une valeur minimale de section, toutes d'une phase d'échantillonnage τsel(k) obtenue sous la forme de la phase d'échantillonnage sélectionnée par les moyens de sélection, et l'obtention de la phase d'échantillonnage τs sur la base de la valeur moyenne pondérée de section, de la valeur maximale de section et de la valeur minimale de section.

**21.** Procédé selon la revendication 20, comprenant :

l'échantillonnage des signaux de réception à l'intervalle de symbole T, en partant d'un instant de début estimé déterminé par un mécanisme de synchronisation de trame,

l'obtention d'un terme de transformation de coordonnées conformément à l'instant de début estimé, l'addition du terme de transformation de coordonnées à la phase d'échantillonnage $\tau$sel(k), l'obtention de la valeur moyenne pondérée de section, d'une valeur maximale de section et d'une valeur minimale de section de la phase d'échantillonnage $\tau$sel(k), après l'addition du terme de transformation de coordonnées à la phase d'échantillonnage $\tau$sel(k), et le calcul de la phase d'échantillonnage $\tau$s respectivement en soustrayant de la valeur moyenne pondérée de section et en additionnant à celle-ci le terme de transformation de coordonnées et une seconde valeur résultante, la seconde valeur résultante étant obtenue en

(1) soustrayant la valeur absolue du terme de transformation de coordonnées, et la valeur minimale de section, de la valeur maximale de section pour obtenir une première valeur résultante, et

(2) multipliant la première valeur résultante par une constante pour obtenir la seconde valeur résultante.

**22.** Procédé selon la revendication 21, dans lequel

on échantillonne les signaux de réception à l'intervalle de symbole T en relation avec les phases d'échantillonnage respectives des séquences de phases d'échantillonnage $\tau = \{\tau(i)\}$ (i = 1, 2, ..., M), en partant d'un instant de début estimé Et slot (k) déterminé par un mécanisme de synchronisation de trame, au moment du traitement du k-ième créneau temporel assigné, pour obtenir des séquences de valeurs d'échantillons $y_i = \{y_{in}\}$ (i = 1, 2, ..., M; n = 1, 2, ..., Nt) des signaux de réception,

on obtient les fonctions d'intercorrélation complexes Ci des séquences d'apprentissage $\phi$ sur la base des séquences de valeurs d'échantillons yi et des séquences d'apprentissage $\phi = \{\phi_n\}$ (n = 1, 2, ..., Nt) des séquences de valeurs d'échantillons yi, conformément à l'équation suivante :

$$Ci = \sum_{j=1}^{Nt} yij(\Phi j*)$$

(avec i = 1, 2, ..., M; et * indique que la conjugaison complexe est utilisée),
et

on obtient

(a) le terme de transformation de coordonnées sous la forme d'un terme de transformation de coordonnées tc(k), conformément aux équations données ci-dessous :

$$\Delta tc(k) = Et\ slot\ (k) - Et\ slot\ (k-1) \qquad k > 1$$

$$tc(k) = \begin{cases} \sum_{i=1}^{k-1} \Delta tc(i) & k > 1 \\ \\ 0 & k = 1 \end{cases}$$

(b) la valeur moyenne pondérée de section, la valeur maximale de section et la valeur minimale de section, respectivement sous la forme d'une valeur moyenne pondérée de section $\tau$ avg (k), d'une valeur maximale de section $\tau$ max (k) et d'une valeur minimale de section $\tau$ min (k) de la phase d'échantillonnage $\tau$sel(k), conformément aux équations suivantes :

$$\tau\max(k) = \begin{cases} \max_{1 \le j \le k} (\tau sel(j) + tc\,(j)) & k < Ls \\[2em] \max_{k - Ls + 1 \le j \le k} (\tau sel(j) + tc\,(j)) & k \ge Ls \end{cases}$$

$$\tau\min(k) = \begin{cases} \min_{1 \le j \le k} (\tau sel(j) + tc\,(j)) & k < Ls \\[2em] \min_{k - Ls + 1 \le j \le k} (\tau sel(j) + tc\,(j)) & k \ge Ls \end{cases}$$

$$\tau avg(k) = \begin{cases} \dfrac{\sum\limits_{j=1}^{k} (wa\,(k - j + 1)\,(\tau sel(j) + tc\,(j)))}{\sum\limits_{j=1}^{k} wa\,(j)} & k < Ls \\[3em] \dfrac{\sum\limits_{j=k-Ls+1}^{k} (wa\,(k - j + 1)\,(\tau sel(j) + tc(j)))}{\sum\limits_{j=1}^{Ls} wa\,(j)} & k \ge Ls \end{cases}$$

(avec les notations suivantes : wa (j= (j = 1, 2, ..., Ls) est un coefficient de pondération et Ls désigne une longueur de calcul maximale),
et
(c) la phase d'échantillonnage sélective $\tau S$ conformément à l'équation suivante :

$$\tau S = \tau\, avg(k) - tc(k) + ws\, (\tau\max(k) - \tau\min (k) - |tc\,(k)|)$$

(avec les notations suivantes : ws désigne le coefficient de décalage, wa (j) (j = 1, 2, ..., Ls) est un coefficient de pondération, et Ls désigne la longueur de calcul maximale).

**23.** Procédé selon la revendication 20, comprenant :

l'échantillonnage des signaux de réception à l'intervalle de symbole T, en partant d'un instant de début estimé, déterminé par un mécanisme de synchronisation de trame, et
l'obtention d'un premier et d'un second termes de transformation de coordonnées conformément à l'instant de début estimé, l'addition du second terme de transformation de coordonnées à la phase d'échantillonnage $\tau sel(k)$, l'obtention de la seconde valeur moyenne pondérée de section, de la valeur maximale de section et de la valeur minimale de section de la phase d'échantillonnage τsel(k), après l'addition du second terme de transformation de coordonnées à la phase d'échantillonnage τsel(k), et le calcul de la phase d'échantillonnage τsel en soustrayant respectivement la valeur minimale de section et la valeur absolue du premier terme de transformation de coordonnées de la valeur maximale de section, pour obtenir une première valeur résultante, en multipliant la première valeur résultante par une constante pour obtenir une seconde valeur résultante, et en additionnant la seconde valeur résultante à la valeur moyenne pondérée de section.

**24.** Estimateur de séquence à vraisemblance maximale selon la revendication 22, comprenant :

l'échantillonnage des signaux de réception introduits à partir des lignes de transmission, à l'intervalle de symbole T, en relation avec les phases d'échantillonnage respectives des séquences de phases d'échantillonnage τ = {τ (i)} (i = 1, 2, ..., M), en partant du créneau temporel de début estimé Et slot (k), déterminé par le mécanisme de synchronisation de trame, au moment du traitement du k-ième créneau temporel assigné, pour obtenir les séquences de valeurs d'échantillons $y_i$ = {yin} (i = 1, 2, ..., M; n = 1, 2, ..., Nt) des signaux de réception y(t), l'obtention d'une fonction d'intercorrélation complexe Ci des séquences d'apprentissage $\phi$ sur la base des séquences de valeurs d'échantillons yi et des séquences d'apprentissage $\Phi$ = {φn} (n = 1, 2, ..., Nt) des séquences de valeurs d'échantillons $y_i$, conformément à l'équation suivante :

$$Ci = \sum_{j=1}^{Nt} yij(\Phi j*)$$

(avec i = 1, 2, ..., M; et * indique que la conjugaison complexe est utilisée),
et
l'obtention

(a) des premier et second termes de transformation de coordonnées, respectivement sous la forme d'un premier terme de transformation de coordonnées tc1(k) et d'un second terme de transformation de coordonnées tc2(j, k), conformément aux équations suivantes, au moment de la k-ième sélection de phase d'échantillon :

$$\Delta tc(k) = \begin{cases} Et\ slot\ (k) - Et\ slot\ (k - 1) & k > 1 \\ 0 & k \le 1 \\ 0 & k \le 1 \end{cases}$$

$$tc1(k) = \begin{cases} \sum_{i=1}^{k-1} \Delta tc\ (i + 1) & k < Ls \\ \sum_{i=k-Ls}^{k-1} \Delta tc\ (i + 1) & k \ge Ls \end{cases}$$

$$tc2(j, k) = \begin{cases} \sum_{i=j}^{k-1} \Delta tc\,(i + 1) & j < k \\ \\ 0 & j \geq k, \end{cases}$$

(b) de la valeur moyenne pondérée de section, la valeur maximale de section et la valeur minimale de section, respectivement sous la forme d'une valeur moyenne pondérée de section $\tau$ AVG (k), d'une valeur maximale de section T MAX (k) et d'une valeur minimale de section $\tau$ MIN (k) de la phase d'échantillonnage $\tau$sel(k), conformément aux équations suivantes :

$$\tau MAX(k) = \begin{cases} \max_{1 \leq j \leq k} (\tau sel(j) + tc2(j, k)) & k < Ls \\ \\ \max_{k - Ls + 1 \leq j \leq k} (\tau sel(j) + tc2(j, k)) & k \geq Ls \end{cases}$$

$$\tau MIN(k) = \begin{cases} \min_{1 \leq j \leq k} (\tau sel(j) + tc2(j, k)) & k < Ls \\ \\ \min_{k - Ls + 1 \leq j \leq k} (\tau sel(j) + tc2(j, k)) & k \geq Ls \end{cases}$$

$$\tau AVG(k) = \begin{cases} \dfrac{\sum_{j=1}^{k} \{wa\,(k - j + 1)\,(\tau sel(j) + tc2(j, k))\}}{\sum_{j=1}^{k} wa\,(j)} & k < Ls \\ \\ \dfrac{\sum_{j=k-Ls+1}^{k} \{wa\,(k - j + 1)\,(\tau sel(j) + tc2(j, k))\}}{\sum_{j=1}^{Ls} wa\,(j)} & k \geq Ls \end{cases}$$

(avec les notations suivantes : wa (j) = (j = 1, 2, ..., Ls) est un coefficient de pondération et Ls désigne la longueur de calcul maximale),
et

(c) de la phase d'échantillonnage de sélection $\tau$s conformément à l'équation suivante :

$$\tau s = \tau\, AVG\,(k) + ws\,(\tau\, MAX\,(k) - T\, MIN\,(k) - |tc1\,(k)\,|)$$

(avec les notations suivantes : ws indique le coefficient de décalage, wa (j) (j = 1, 2, ..., Ls) est un coefficient de pondération, et Ls désigne la longueur de calcul maximale).

**25.** Procédé selon la revendication 18, 19, 21 ou 23, incluant :

l'application d'un retard au signaux de réception,
l'échantillonnage des signaux de réception retardés,
l'obtention de premières valeurs estimées E|h {Ehj} (j = 0, 1, ..., L) de la réponse impulsionnelle de la voie de transmission, à partir des séquences de valeurs d'échantillons $\mathcal{Y}$, et des séquences d'apprentissage $d$ correspondant aux séquences de valeurs d'échantillons $\mathcal{Y}$ , conformément à un algorithme d'égalisation adaptative,
l'obtention de valeurs estimées Eh à partir des séquences de valeurs d'échantillons $\mathcal{Y}$ et des valeurs estimées $\mathbf{Ex}$ = {Exn} (n = 1, 2, ... N) des séquences de symboles de transmission, conformément à l'algorithme d'égalisation adaptative, et
l'obtention des valeurs estimées $\mathbf{Ex}$ conformément à un algorithme de Viterbi.

Fig. 1 (a)

Fig. 1 (b)

ST201 ～ RECEIVES INCOMING SIGNAL y(t) AND SAMPLING PHASE $\tau$ s

ST202 ～ SAMPLES y(t) TO y={y (Et slot(K)+ $\tau$ s+(n—1)T}(n=1,2,···,M)

ST203 ～ GIVES y TO VITERBI ALGORITHM PROCESSING PART AND TRANSMISSION LINE ESTIMATING PART

## FIG. 2

ST301 ～ RECEIVES y AND Eh

ST302 ～ OBTAIN Ex FROM y AND Eh ACCORDING TO VITERBI ALGORITHM

ST303 ～ OUTPUTS Ex

## FIG. 3

RECEIVES y ～ ST401

ST402 WHICH SYSTEM OF TIME SLOT IS PROCESSED?

SYNC SEQUENCE

OTHER THAN SYNC SEQUENCE

ST403 RECEIVES $\phi$

ST405 RECEIVES Ex

ST404 OBTAIN Eh FROM $\phi$ AND y

ST406 OBTAIN Eh FROM Ex AND y

GIVES Ehj TO VITERBI ALGORITHM PROCESSING PART ～ ST407

## FIG. 4

60

ST501 —
> SAMPLES INCOMING SIGNAL y(t) IN REFERENCE TO
> $\{y(Et\ slot(k)+\tau(i)+(n-1)T)\}$   $(i=1,2,\cdots,M, n=1,2,\cdots,Nt)$
> AND OBTAIN SAMPLE VALUE SEQUENCE $y_i$

ST502 —
> OBTAIN COMPLEX CROSS-CORRELATION Ci FROM $y_i$ AND
> TRAINING SEQUENCE $\phi$ ACCORDING TO
> $$C_i = \sum_{j=1}^{Nt} y_{ij} \cdot (\phi_j *)(i=1,2,\cdots,M)$$

ST503 —
> OBTAIN INDEX Ik WHERE |Ci| IS MAXIMUM FROM M CiS

ST504 —
> FROM Ik, OBTAIN:
> SECTION MAXIMUM INDEX Imax(k)
> SECTION MINIMUM INDEX Imin(k)
> SECTION WEIGHTED MEAN INDEX Iavg(k)

ST505 —
> FROM Imax(k), Imin(k) AND Iavg(k),
> OBTAIN SELECTIVE SAMPLING INDEX Is
> Is＝[Iavg(k)+Ws(Imax(k)−Imin(k))]

ST506 —
> OBTAIN SAMPLING PHASE $\tau$ s BY INSERTING
> Is INTO MAXIMUM AND MINIMUM VALUES

ST507 —
> GIVES $\tau$ s TO SAMPLING DATA PROCESSING PART

# FIG. 5

EP 0 602 249 B1

I FRAME

| Slot I | Slot 2 | Slot 3 | Slot 4 | Slot 5 | Slot 6 |
|--------|--------|--------|--------|--------|--------|

I TIME SLOT

| 28bit | 12 bit | 130bit | 12bit | 130bit | 12bit |
|-------|--------|--------|-------|--------|-------|
| SYNC | SACCH | DATA | CDYCC | DATA | RSYD |

# FIG.6

EP 0 602 249 B1

**FIG. 7**

FIG. 8

FIG. 9

FIG.IO

F I G. II

Fig. 12(a)

Fig. 12(b)

ST1301 — 
| SAMPLES INCOMING SIGNAL y(t) ACCORDING TO |
| yi={y(Et slot(k)+ $\tau$ (i)+(n−1)T)}   (i=1,2,···,M,n=1,2,···,Nt) |
| AND OBTAIN SAMPLE VALUE SEQUENCE yi |

ST1302 — 
OBTAIN COMPLEX CROSS-CORRELATION Ci FROM yi AND
TRAINING SEQUENCE  $\phi$ ACCORDING TO
$$Ci = \sum_{j=1}^{Nt} y\,ij \cdot (\phi j *)(i=1,2,\cdots,M)$$

ST1303 — 
OBTAIN INDEX Ik WHERE | Ci | IS THE MAXIMUM VALUE
FROM M CiS

ST1304 — 
FROM Ik,OBTAIN:
MAXIMUM INDEX Imax(k)
MINIMUM INDEX Imin(k)
WEIGHTED MEAN INDEX Iavg(k)

ST1305 — 
FROM Imax(k), Imin(k) AND Iavg(k),
OBTAIN SELECTIVE SAMPLING INDEX Is
Is=[I avg(k)+Ws(Imax(k)−Imin(k))]

ST1306 — 
OBTAIN SAMPLING PHASE  $\tau$ s BY INSERTING
Is INTO MAXIMUM AND MINIMUM VALUES

ST1307 — 
GIVES  $\tau$ s TO SAMPLING DATA PROCESSING PART

# FIG. 13

Fig. 14 (a)

Fig. 14 (b)

ST1501 — SAMPLES INCOMING SIGNAL y(t) ACCORDING TO
$$y_i = \{y(Et\ slot(k) + \tau(i) + (n-1)T)\} \quad (i=1,2,\cdots,M, n=1,2,\cdots,Nt)$$
AND OBTAIN SAMPLE VALUE SEQUENCE $y_i$

ST1502 — OBTAIN COMPLEX CROSS-CORRELATION $C_i$ FROM $y_i$ AND TRAINING SEQUENCE $\phi$ ACCORDING TO
$$C_i = \sum_{j=1}^{Nt} y_{ij} \cdot (\phi_j *) (i=1,2,\cdots,M)$$

ST1503 — OBTAIN SAMPLING PHASE $\tau\ sel(k)$
WHERE $|C_i|$ IS MAXIMUM FROM M $C_i$S

ST1504 — OBTAIN COORDINATE TRANSFORMATION TERM FROM Et slot(k)

ST1505 — FROM $\tau\ sel(k)$ AND tc(k), OBTAIN:
SECTION MAXIMUM SAMPLING PHASE $\tau\ max(k)$
SECTION MINIMUM SAMPLING PHASE $\tau\ min(k)$
SECTION WEIGHTED MEAN SAMPLING PHASE $\tau\ avg(k)$

ST1506 — FROM tc(k), $\tau\ max(k)$, $\tau\ min(k)$ AND $\tau\ avg(k)$,
OBTAIN SAMPLING PHASE $\tau\ s$ ACCORDING TO
$$\tau\ s = \tau\ avg(k) - tc(k) + Ws(\tau\ max(k) - \tau\ min(k) - |tc(k)|)$$

ST1507 — GIVES $\tau\ s$ TO SAMPLING DATA PROCESSING PART

# FIG. 15

y(t) → DELAY PROCESSING PART /110 → SAMPLING DATA PROCESSING PART /120 → y → VITERBI ALGORITHM PROCESSING PART /130 → Ex

SAMPLING PHASE COMPUTING PART /400   τs

Fig. 16(a)

Eh /140

TRANSMISSION LINE ESTIMATING PART ← /150

φ

Fig. 16(b)

τ(1)

SAMPLING PART /101-1 → $y_1$ → CORRELATION VALUE CALCULATOR /102-1 → $C_1$

y(t)

φ

τ(M)

SAMPLING PART /101-M → $y_M$ → CORRELATION VALUE CALCULATOR /102-M → $C_M$

φ

MAXIMUM CORRELATION SAMPLING PHASE SELECTOR /302   τ sel(k)

Et slot(k)

SAMPLING PHASE SMOOTHER /401 → τs

ST1701 — SAMPLES INCOMING SIGNAL $y(t)$ ACCORDING TO
$y_i = \{y(Et\ slot(k) + \tau(i) + (n-1)T)\}$ $(i=1,2,\cdots,M, n=1,2,\cdots,Nt)$
AND OBTAIN SAMPLE VALUE SEQUENCE $y_i$

ST1702 — OBTAIN COMPLEX CROSS-CORRELATION $C_i$ FROM $y_i$ AND
TRAINING SEQUENCE $\phi$ ACCORDING TO
$C_i = \sum\limits_{j=1}^{Nt} y_{ij} \cdot (\phi_j *)(i=1,2,\cdots,M)$

ST1703 — OBTAIN SAMPLING PHASE $\tau\ sel(k)$
WHERE $|C_i|$ IS MAXIMUM FROM M $C_i$S

ST1704 — OBTAIN FIRST COORDINATE TRANSFORMATION TERM
$tc1(k)$ AND SECOND TRANSFORMATION TERM $tc2(k)$
FROM $Et\ slot(k)$

ST1705 — FROM $\tau\ sel(k)$ AND $tc2(k)$,OBTAIN:
SECTION MAXIMUM SAMPLING PHASE $\tau\ MAX(k)$
SECTION MINIMUM SAMPLING PHASE $\tau\ MIN(k)$
SECTION WEIGHTED MEAN SAMPLING PHASE $\tau\ AVG(k)$

ST1706 — FROM $tc1(k)$, $\tau\ MAX(k)$, $\tau\ MIN(k)$ AND $\tau\ AVG(k)$,
OBTAIN SAMPLING PHASE $\tau\ s$ ACCORDING TO
$\tau\ s = \tau\ AVG(k) + Ws(\tau\ MAX(k) - \tau\ MIN(k) - |tc1(k)|)$

ST1707 — GIVES $\tau\ s$ TO SAMPLING DATA PROCESSING PART

# FIG. 17